# EUROPEAN PATENT APPLICATION

(11) **EP 1 681 729 A1**
(43) Date of publication of application: **19.07.2006**
(21) Application number: 04793117.5
(22) Date of filing: 28.10.2004
(51) Int. Cl.: H01L 33/00, H01L 31/02

(54) **SEALED STRUCTURE OF OPTICAL DEVICE, OPTICAL COUPLER, AND METHOD FOR SEALING OPTICAL DEVICE**

(30) Priority: 31.10.2003 JP 2003372963; 17.03.2004 JP 2004076781
(71) Applicant: SHARP KABUSHIKI KAISHA, Osaka-shi, Osaka 545-8522 (JP)
(72) Inventor: FUJITA, Hideaki, 6360247 (JP); IWAKI, Tetsuo, 6391041 (JP); ISHII, Yorishige, 6350052 (JP)
(74) Representative: Müller, Frithjof E.
(86) International application number: PCT/JP2004/016009
(87) International publication number: WO 2005/043634

(57) **Abstract**

An object of the invention is to provide an optical element sealing structure that has good environmental resistance, and can be reduced in size. A sealing structure includes a lead frame (30) having a light transmitting section (38), an optical element (22) having an optical surface (41) which is directed to the light transmitting section (38) and is mounted on the lead frame (30) in such a state that the optical element blocks the light transmitting section (38) at its one end portion (48) in an axis direction, and a sealing body (29) that is formed in a region excluding an optical path (80) and seals the optical element (22). By forming the sealing body (29) in the region excluding the optical path (80), the light usage efficiency can be prevented from decreasing even when a material that can increase the environmental resistance is added to the sealing body. Further, since the optical element (22) is mounted on the lead frame (30) with its face down, the sealing structure (20) can be easily formed even when the optical element (22) is small-sized.

## Description

### Technical Field

The present invention relates to an optical element sealing structure of sealing therein an optical element, and exemplarily, relates to a sealing structure of sealing therein an optical coupler for use for an optical communications link or others over which optical signals are transmitted and received using a transmission medium of optical fibers.

### Background Art

Optical couplers are used for optical communications between devices, in households, and in vehicles. The optical couplers are apparatuses for establishing an optical coupling between optical elements and optical fibers. For example, the optical elements are exemplified by a light emitting diode (LED, Light Emitting Diode), a photo diode (PD, Photo Diode), and the like. The optical coupler is of a sealing structure in which such an optical element is sealed by using a molding resin.

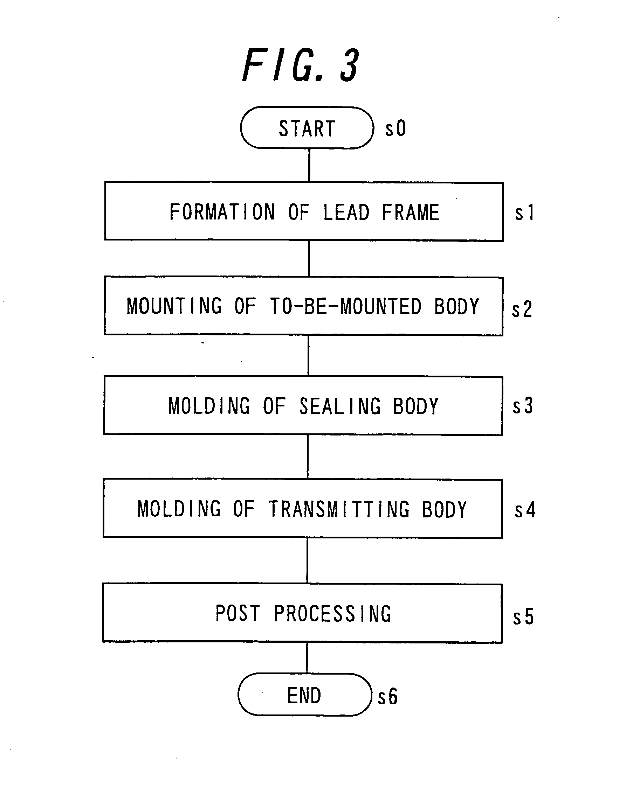

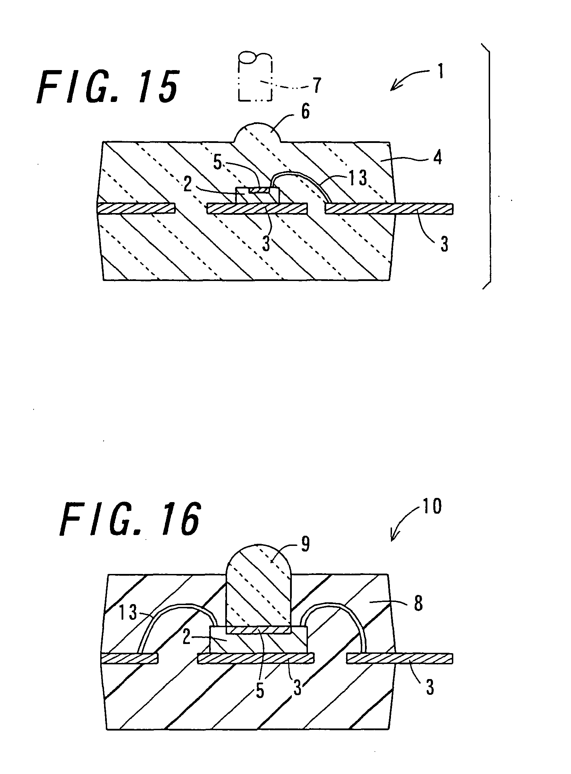

FIG. 15 is a cross sectional view of a sealing structure 1 of a first related-art technology. In Japanese Unexamined Patent Publication JP-A 2000-173947, the sealing structure 1 of the first related-art technology is disclosed in FIG. 3. In this sealing structure 1, a lead frame 3 carries thereon an optical element 2, and the optical element 2 is covered with a transparent sealing resin 4. The sealing resin 4 is formed with a lens portion 6 at the position facing an optical surface 5 of the optical element 2.

When the optical element 2 is a light-emitting element, the light coming from the optical surface 5 passes through the sealing resin 4. The light is then gathered by the lens portion 6 of the sealing resin 4, and enters an optical fiber 7. When the optical element 2 is a light-receiving element, the light coming from the optical fiber 7 enters the sealing resin 4. This light is gathered by the lens portion 6 of the sealing resin 4, passes through the sealing resin 4, and then enters the optical surface 5. As such, the optical fiber 7 and the optical element 2 are put into the state ready for optical transmission, i.e., optically coupled.

FIG. 16 is a cross sectional view of a sealing structure 10 of a second related-art technology. In JP-A 2000-173947, the sealing structure 10 of the second related-art technology is disclosed in FIG. 1. In this sealing structure 10, the optical element 2 is covered with a sealing resin including therein a filler, i.e., by a filler-included sealing resin 8. The filler-included sealing resin 8 is formed in an optical-path remaining region, which excludes an optical path region for the light coming and going from/to the optical element 2. The optical path region is provided with a light transmitting lens element 9. The lens element 9 is implemented by a transparent resin or glass. Herein, the optical surface 5 of the optical element 2 is formed on a side opposite to a lead frame 30 therein. The light traveling the optical path formed between the optical surface 5 and the optical fiber 7 passes through the lens element 9 without being blocked by the filler-included resin 8.

As an alternative to the lens element 9 of the sealing structure 10 in the second related-art technology, in Japanese Unexamined Patent Publication JP-A 59-167037 (1984), disclosed in FIG. 2(f) is the technology of using, as a sealing structure of a third related-art technology, a light-transmitting plate whose light-entering surface and light-exiting surface are both flat. This light-transmitting plate is made of an inorganic material or an organic material.

Also as an alternative to the lens element 9 of the sealing structure 10 in the second related-art technology, in Japanese Unexamined Patent Publication JP-A 61-51853 (1986), disclosed in FIG. 2 is the technology of using, as a sealing structure of a fourth related-art technology, a light-transmitting resin in which a light-entering surface and a light-exiting surface are evenly formed. This light-transmitting resin includes an inorganic filling material, i.e., filler, for adjusting the thermal expansion coefficient.

In the first related-art technology, the light passes through the sealing resin 4. As is including a filler, the sealing resin 4 can increase the environmental resistance of the optical element 2. The sealing resin 4 is, however, reduced in light transmittance as the filler content is increased. When the light transmittance is reduced, the amount of light transmission is reduced between the optical fiber 7 and the optical element 2. Therefore, in the first related-art technology, the sealing resin 4 includes no or little filler even if allowed. This thus causes a problem that the sealing structure 1 cannot increase both the environmental resistance of the optical element 2 and the light transmission rate therefor. This problem arises also in the fourth related-art technology.

In the second related-art technology, when the lens element 9 is implemented by glass, the lens element cannot be formed by molding so that the resulting optical coupler cannot be manufactured with low cost.

When the optical element 2 for use is relatively large in size of a few mm to a few tens of mm square, e.g., CCD (Charge Coupled Device) image sensor, the optical surface 5 can carry thereon the glass lens 9. When using the optical element 2 small in size of a few hundreds of µm square such as LED, however, because the optical surface 5 is very small in size, the glass lens 9 is also required to be very small in size.

With this being the case, there are three problems of a difficulty in designing a lens that can lead to optical effects, a difficulty in manufacturing the glass lens 9 minute in size, and a difficulty in attaching together the optical surface 5 and the glass lens 9, and positioning thereof. What is more, when using the glass lens 9 being larger than the optical surface 5 of the optical element 2, the glass lens 9 is connected in the vicinity of the optical surface 5. This thus arises a problem of causing a difficulty in wire bonding between an electrode to be formed in the vicinity of the optical surface 5 and the lead frame 30. Such a problem also arises in the third related-art technology.

Assuming that the lens element 9 is implemented by resin, when using the optical element 2 being small in size, e.g., LED, the optical surface 5 is small so that it is difficult to take measures thereagainst due to the same reason as with the case where the lens element 9 is implemented by glass. Moreover, when such a resin lens 9 is used,in view of the heat resistance of the lens, there needs to attach the resin lens 9 to the optical surface 5 of the optical element 2 after sealing is completed using the filler-included sealing resin 8.

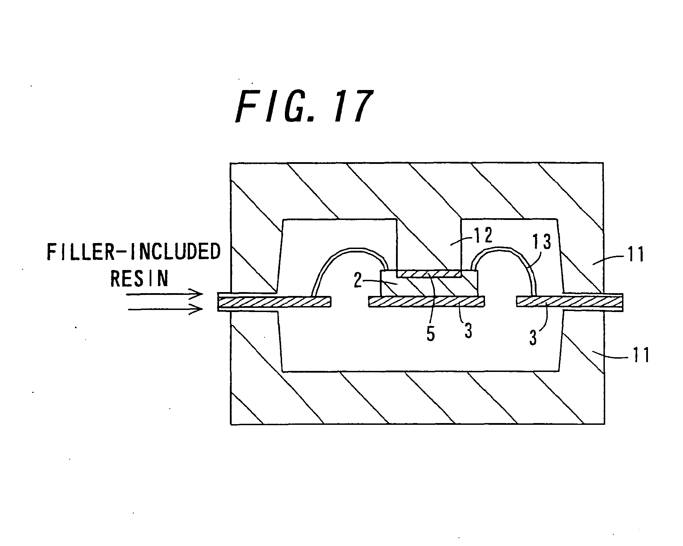

FIG. 17 shows the state in which the lead frame 3 carrying thereon the optical element 2 is attached to a mold. When the resin lens 9 is used, at the time of molding of the filler-included sealing resin 8, there needs to prevent the filler-included sealing resin 8 from reaching the optical surface 5 of the optical element 2. Therefore, in consideration of warpage or others of the lead frame 3, there needs to apply pressure to the optical surface 5 of the optical element 2 using a facing portion 12 of a molding mold 11.

Once the optical surface 5 is applied with pressure; the optical surface 5 may partially chip or the optical characteristics of the optical element 2 may suffer from adverse effects. What is worse, the facing portion 12 may come into contact with a wire 13 that is disposed in the vicinity of the optical surface 5. To preclude such a possibility; there needs to fulfill both the mold management with high precision, and the deformation prevention of the lead frame 3, but this is not easy. Especially with the optical element being small in size such as an LED, it is quite difficult not to make the filler-included sealing resin 8 find its way to the optical surface 5 while the wire 13 being protected.

### Disclosure of Invention

In consideration of the above, an object of the invention is to provide an optical element sealing structure that has good environmental resistance, and can be reduced in size.

The invention is directed to an optical element sealing structure comprising:
a mounting body provided with a light transmitting section through which light traveling along a predetermined optical path passes;
an optical element having an optical surface receiving or emitting light which is directed to the light transmitting section, and is mounted on the mounting body in such a state that the optical element blocks the light transmitting section at one end portion in an axis direction thereof; and
a sealing body that is formed in a region excluding the optical path, and seals the optical element mounted on the mounting body.

According to the invention, when the optical surface is a light-emitting surface, the light coming from the optical surface passes through the light transmitting section, and then exits from the mounting body. When the optical surface is a light-receiving surface, the light traveling from the outside of the mounting body toward the mounting body passes through the light transmitting section, and then enters the optical surface of the optical element. The sealing body does not block the movement of light by being formed in the region excluding the optical path. Accordingly, the sealing body is not required to have the light transmitting characteristics. Thanks thereto, even if any colored sealing body is used, the light passing through the light transmitting section is not reduced in amount so that the selection options for the sealing body can be increased.

The optical surface serves as a heat-producing source for the optical element. In the invention, the optical surface is disposed facing the mounting body so that the heat produced on the optical surface is easily transferred to the mounting body, and the heat dissipation characteristics of the optical element can be increased. In the optical element, the optical surface and the neighboring portion of the optical surface are in contact with the mounting body. Therefore, in the optical element, the optical surface and the neighboring portion of the optical surface are not required to be sealed by the sealing body. Accordingly, even if the optical element is small in size, it can be manufactured with ease.

For example, by using a molding resin for the sealing body, the sealing structure can be manufactured by molding. With this being the case, the optical element is mounted on the mounting body in such a state that the optical element blocks the light transmitting section of the mounting body at one end portion in the axis direction thereof. Next, in the optical element, any portion excluding the surface portion facing the mounting body is covered by the molding resin for a molding process. In this manner, the sealing structure can be manufactured.

Furthermore, the invention is characterized that a material that can increase the environmental resistance of the optical element is added to the sealing body.

According to the invention, even if the sealing body is colored, the light transmission rate is never reduced. Therefore, even if any colored additive for the purpose of increasing the environmental resistance of the optical element is added to the sealing body, the environmental resistance can be increased without reducing the light transmission rate.

The environmental resistance is exemplified not only by the heat shock resistance and the heat dissipation characteristics but also by the moisture resistance, the heat resistance, the cold resistance, the stable performance characteristics under high temperature, the stable performance characteristics in the.state of low temperature, and the resin strength enhancement characteristics. When the sealing body is the molding resin, these can be implemented by putting a filling material called filler in the sealing body. Alternatively, the sealing body may be provided with any material for deriving the mold releasability, the flame resistance, and the coloring characteristics.

Furthermore, the invention is characterized by further comprising:
a connection body for establishing an electrical connection to the optical element; and
a wire for establishing an electrical connection between the optical element and the connection body,
wherein a linear expansion coefficient of the sealing body is set to be almost equal to a linear expansion coefficient of the wire or the optical element.

According to the invention, by setting the linear expansion coefficient of the sealing body to be almost equal to that of the wire or the optical element, in response to any temperature change, the stresses to be produced to the optical element or the wire can be reduced so that the optical element or the wire can be protected from any possible damage. What is more, even if the sealing body is added with any colored filling material in order to change the linear expansion coefficient, the light passing through the light transmitting section does not attenuate so that the light passing through the light transmitting section is not reduced in light transmission rate.

Furthermore, the invention is characterized in that the sealing body is formed in a region of the optical element opposite to the mounting body.

According to the invention, when the sealing body is formed by molding, a mold is filled with a molding resin with the inner surface of the mold being in contact entirely with any surface portion of the mounting body opposite to the optical element. The optical element is thus covered with the molding resin so that the sealing structure can be manufactured.

Furthermore, the invention is characterized by further comprising a transmitting body whose light transmittance is higher than that of the sealing body,
wherein the transmitting body blocks the other end portion of the light transmitting section in the axis direction.

According to the invention, the transmitting body blocks the other end portion of the light transmitting section in the axis direction so that the optical surface is prevented from being exposed. What is more, because the transmitting body is high in light transmittance so that the light passing through the light transmitting section can be prevented from being lowered in light transmission rate.

Furthermore, the invention is characterized in that the sealing body and the transmitting body are made of a molding resin, and are formed by transfer molding.

According to the invention, by forming the sealing body and the transmitting body using the molding resin, the sealing structure can be easily manufactured with low cost. Especially with transfer molding, the sealing structure can be manufactured in volume so that the sealing structure can be manufactured with lower cost.

Furthermore, the invention is characterized in that a first contact area at which the transmitting body is in contact with the mounting body is larger than a second contact area at which the transmitting body is in contact with the sealing body.

According to the invention, when the sealing body is formed by molding, the mold release agent seeps through the surface of the sealing body. Therefore, any portion of the transmitting body being in contact with the sealing body is not fully attached therewith. In the invention, by forming the first contact area larger than the second contact area, the attachment level of the transmitting body can be increased. This thus enables to prevent the transmitting body from falling off.

Furthermore, the invention is characterized in that at least a part of an outer peripheral portion of the transmitting body is in contact with the mounting body.

According to the invention, when the sealing body is formed by molding, the mold release agent seeps through the surface of the sealing body. Therefore, any portion of the transmitting body being in contact with the sealing body is not fully attached therewith. In the invention, when any external force is applied or any heat change occurs, any stresses are produced in the transmitting body. These stresses are increased at the outer peripheral portion of the transmitting body. According to the invention, at least a portion of the outer peripheral portion is in contact with the mounting body so that when any stresses are produced, the transmitting body is prevented from falling off.

Furthermore, the invention is characterized in that both the sealing body and the mounting body are covered with the transmitting body.

According to the invention, by covering both the sealing body and the mounting body with the transmitting body, the transmitting body can be prevented from falling off with certainty.

Furthermore, the invention is characterized in that the transmitting body is attached to the mounting body or the sealing body using an adhesive.

According to the invention, compared with a case where the transmitting body is formed by transfer molding, the resulting transmitting body can be reduced in size.

Furthermore, the invention is characterized in that the adhesive has a light transmitting property and a refractive index higher than that of air, and is filled between the optical surface of the optical element and the transmitting body.

According to the invention, by covering the optical surface of the optical element with an adhesive whose refractive index is higher than that of air, when an LED is used for the optical element, it becomes possible to increase the external quantum efficiency.

Furthermore, the invention is characterized in that, in at least either the transmitting body or the mounting body, a positioning section is formed for positioning between the transmitting body and the mounting body.

According to the invention, by directly positioning the transmitting body and the mounting body using the positioning section, it becomes possible to easily position both the optical surface of the optical element and the transmitting body with high precision.

Furthermore, the invention is characterized in that the light transmitting section is formed with a through hole that penetrates through the mounting body along the optical path,
the transmitting body is formed with a positioning section that fits into the through hole, and
the positioning section is tapered in shape with which the outer diameter is reduced toward the light-receiving surface of the optical element while the positioning section is fitted into the through hole.

According to the invention, by fitting the positioning section of the transmitting body into the through hole of the mounting body, it becomes possible to position the transmitting body to the mounting body with ease. Also with assembly in which the adhesive filled into the through hole of the mounting body is as if being pushed aside, the adhesive can be uniformly disposed between the transmitting body and the mounting body. What is more, the adhesive can be free from air bubbles.

Furthermore, the invention is characterized in that the attachment area at which the transmitting body is attached to the mounting body or the sealing body is smaller than the surface area on a side where the sealing body is in contact with the mounting body.

According to the invention, on the surface of the mounting body on the side where the transmitting body is attached thereto, an exposure surface can be formed to expose in the atmosphere around the sealing structure so that the heat dissipation characteristics of the sealing structure can be made better.

Furthermore, the invention is characterized in that, in the transmitting body, a lens portion formed in the shape of lens is formed on the optical path.

According to the invention, when the optical surface emits light, the lens portion can suppress the dispersion of light coming from the sealing structure. When the optical surface receives the light, the lens portion gathers the light so that the amount of light entering the optical surface can be increased. This enables to increase the light usage efficiency by the small-sized optical system of simple configuration.

Furthermore, the invention is characterized in that the mounting body includes a lead frame and a sub mount, and
the optical element is mounted on the lead frame via the sub mount.

According to the invention, the involvement of the sub mount can solve any problem that is to be caused when the optical element is mounted directly on the lead frame. For example, when there is a large difference between the linear expansion coefficient of the lead frame and that of the optical element, the stresses of the optical element as a result of any temperature change can be reduced by making the linear expansion coefficient of the sub mount closer in value to that of the optical element. Moreover, compared with the leadframe, the dimension precision can be increased.

Furthermore, the invention is characterized in that the light transmitting section of the mounting body is formed with a light condensing section that narrows the optical path toward the optical surface of the optical element.

According to the invention, when the optical surface emits light, the light condensing section can suppress the dispersion of light coming from the sealing structure. When the optical surface receives the light, the light condensing section gathers the light so that the amount of light entering the optical surface can be increased. In this manner, the optical usage efficiency can be increased by the small-sized optical system of simple configuration.

Furthermore, the invention is characterized in that, in the light transmitting section, an aperture is formed to extend along the optical path, an inner diameter thereof is increased as is away from the optical surface, and an inner surface thereof has a high light reflectivity.

According to the invention, when the light diameter of the light entering the mounting body is larger than the optical surface, as to the light entering the optical surface, by reflection of light on the inner surface, the amount of light entering the optical surface can be increased. Moreover, when the dispersion angle of the light coming from the optical surface is large, as to the light coming from the mounting body, by reflection of light on the inner surface, the dispersion angle of the light coming from the mounting body can be reduced.

Furthermore, the invention is characterized in that the mounting body is formed with an exposure surface that is exposed to the atmosphere around the sealing structure.

According to the invention, by forming the mounting body with an exposure surface that is not covered with the transmitting body, even if the thermal conductivity of the transmitting body is low, the heat can be dissipated from the exposure surface of the mounting body so that the heat dissipation characteristics can be made better for the sealing structure.

Furthermore, the invention is characterized in that the optical element is any one of a light-emitting diode, a semiconductor laser, and a photo diode.

According to the invention, even if the optical element is a small-sized element being any one of a light-emitting diode, a semiconductor laser, and a photo diode, the optical element can be sealed by the sealing body in a state where the optical element is mounted on the mounting body.

The invention is directed also to an optical coupler comprising:
the sealing structure of the optical element, the optical coupler being capable of being optically coupled with a light transmitting medium.

According to the invention, by the optical coupler including the above-described sealing structure, the resulting optical coupler can have good environmental resistance, and can be reduced in size.

Furthermore, the invention is directed to an optical element sealing method for mounting on a mounting body an optical element having an optical surface receiving or emitting light, and sealing the optical element mounted on the mounting body using a molding resin, comprising:
a light transmitting section formation step of forming on the mounting body a light transmitting section though which light traveling along a predetermined optical path goes;
an optical element mounting step of mounting the optical element on the mounting body in such a state the optical surface is directed to the light transmitting section, and the optical element blocks the light transmitting section at one end portion in an axis direction thereof; and
a sealing molding resin molding step of filling a mold with, in a state where the mounting body carrying thereon the optical element is attached to the mold, and in such a state that the mold blocks the light transmitting section at another end portion in the axis direction thereof, a sealing molding resin added with a filling material that increases the environmental resistance of the optical element.

According to the invention, after a light transmitting section is formed by the light transmitting section formation step, the optical element is mounted on the mounting body in such a state that the light transmitting section is blocked by the optical element at its one end portion in the axis direction. Next, a sealing molding resin is filled into a mold so that the sealing body is formed. This can prevent the sealing molding resin from finding its way to the optical surface and therearound. Alternatively, any colored sealing molding resin including the additive for increasing the environmental resistance may be used to seal the optical element by forming the sealing molding resin in the area excluding the optical path. This can also prevent the reduction of the light transmission rate.

When the sealing body is used to seal the optical element, there only needs to fill the sealing molding resin in such a manner as to cover around the optical element mounted on the mounting body. There is thus no need to make the mold come into contact with the optical surface of the optical element. This accordingly eliminates the need to manage the mold with high precision. The optical element can also be free from any possible damage. Even if the optical element is small in size, the sealing body can seal the optical element with ease.

### Brief Description of Drawings

Other and further objects, features, and advantages of the invention will be more explicit from the following detailed description taken with reference to the drawings
wherein:
FIG. 1 is a cross sectional view of a sealing structure 20 in a first embodiment of the invention;
FIG. 2 is a cross sectional view of an optical coupler 21 including the sealing structure 20;
FIG. 3 is a flowchart showing the manufacturing procedure of the sealing structure 20;
FIGS. 4A to 4C are each a diagram showing the manufacturing procedure of the sealing structure 20;
FIG. 5 is a plane view of the sealing structure after formed;
FIG. 6 is a cross sectional view of a sealing structure 120 in a second embodiment of the invention;
FIG. 7 is a cross sectional view of an optical coupler 121 including the sealing structure 120;
FIG. 8 is a cross sectional view of a sealing structure 220 in a third embodiment of the invention;
FIG. 9 is a cross sectional view of a sealing structure 320 in a fourth embodiment of the invention;
FIG. 10 is a cross sectional view of a sealing structure 420 in a fifth embodiment of the invention;
FIG. 11 is a cross sectional view of a sealing structure 520 in a sixth embodiment of the invention;
FIG. 12 is a plane view of the sealing structure 520; FIG. 13 is a flowchart showing the manufacturing procedure of the sealing structure 520 of the sixth embodiment;
FIG. 14 is a cross sectional view for illustrating the manufacturing procedure of the sealing structure 520;
FIG. 15 is a cross sectional view of a sealing structure 1 of a first related-art technology;
FIG. 16 is a cross sectional view of a sealing structure 10 of a second related-art technology; and
FIG. 17 shows the state in which the lead frame 3 carrying thereon the optical element 2 is attached to a mold.

### Best Mode for Carrying out the Invention

Now referring to the drawings, preferred embodiments of the invention are described below.

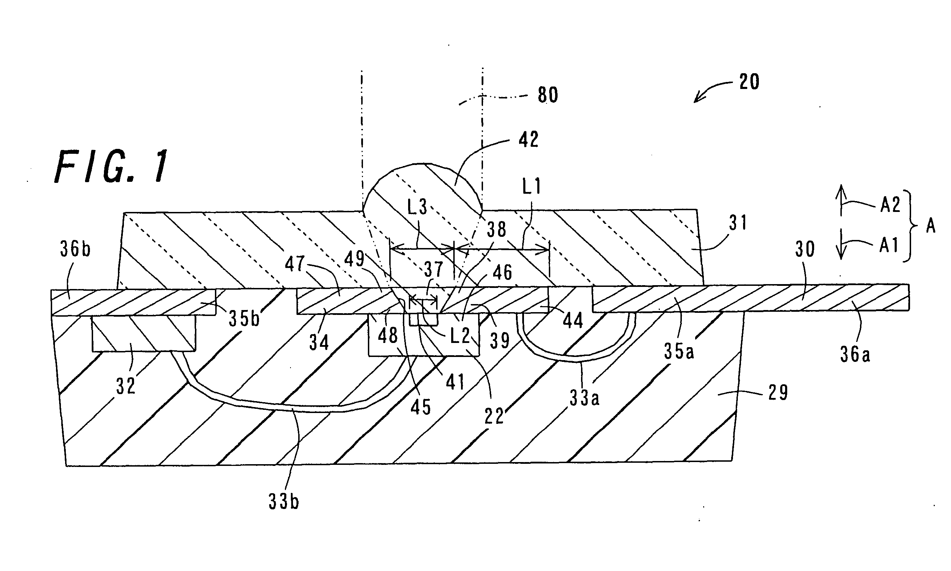

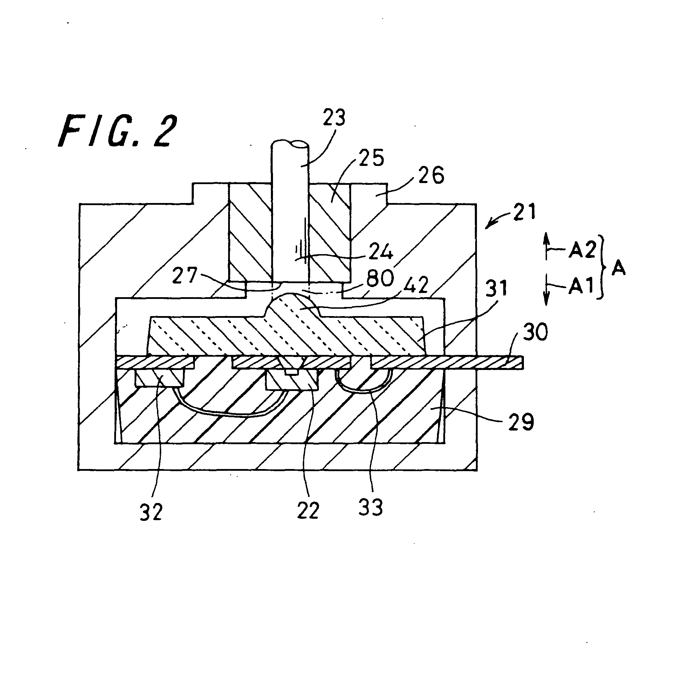

FIG. 1 is a cross sectional view of a sealing structure 20 in a first embodiment of the invention, and FIG. 2 is a cross sectional view of an optical coupler 21 including the sealing structure 20. For optical communications, the optical coupler 21 establishes a connection between an optical element 22 and an optical fiber 23 to be ready for optical transmission, i.e., so-called optical coupling apparatus. The optical element 22 is a semiconductor with the optical function, and for example, is a light-emitting element such as a light emitting diode (LED, Light Emitting Diode), and a light-receiving element such as a photo diode (PD, Photo Diode).

The optical fiber 23 is a cable formed to be flexible and long in length. The optical fiber 23 serves as an optical transfer medium that transfers light from one end portion to the other end portion. That is, light coming from one end portion of the optical fiber 23 passes through the optical fiber 23, and exits from the other end portion of the optical fiber 23. An outer peripheral portion 24 of one end portion of the optical fiber 23 is covered by a plug 25. The plug 25 serves as a coupling portion for coupling to the optical coupler 21.

The optical coupler 21 is formed with a connector section 26 to which the plug 25 fits to be detachable. When the plug 25 is being fit to the connector section 26, a one end surface 27 of the optical fiber 23 comes to the position facing the optical element 22. That is, when the connector section 26 is connected with the plug 25, the optical fiber 23 is positioned with respect to the optical element 22.

The optical coupler 21 is provided with the sealing structure 20 in which the optical element 22 is sealed by a sealing body 29. The sealing structure 20 protects the optical element 22. The sealing structure 20 and the connector section 26 are fixed to be a piece. By fitting the optical fiber 23 to the connector section 26, any possible misalignment can be prevented between the optical fiber 23 and the optical element 22. Further, the positioning can be easily done to the optical fiber 23 and the optical element 22.

As shown in FIG. 1, the sealing structure 20 is configured to include the optical element 22, the lead frame 30, the sealing body 29, a transmitting body 31, a driver circuit 32, and wires 33a and 33b. The lead frame 30 is provided with an optical element mounting section 34, internal connection sections 35a and 35b, and external connection sections 36a and 36b. The optical element mounting section 34 may be a so-called die pad. The internal connection sections 35a and 35b each may be a so-called inner lead. The external connection sections 36a and 36b each may be a so-called outer lead. Such a lead frame 30 is formed like a plate. Hereinafter, the thickness direction of the lead frame 30 is simply referred to as thickness direction A. Note that, in this embodiment, the optical element mounting section 34 of the lead frame 30 serves as a mounting body in which the optical element 22 is mounted on the surface portion on a side in one thickness direction A1.

An electrode terminal of the optical element 22 and an electrode terminal of the optical element mounting section 34 are attached together in the electrically-continuous state. The electrode terminal of the optical element mounting section 34 is electrically connected to its corresponding internal connection section 35a by the first wire 33a. The internal connection section 35a connected by the first wire 33a is linked to its corresponding external connection section 36a, and is exposed toward outside of the sealing structure 20. This enables to forward an electric signal to the optical element 22 from any external device of the sealing structure 20 via the external connection section 36a. This also enables to forward an electric signal from the optical element 22 to any external device of the sealing structure 20 via the external connection section 36a. Note here that, alternatively, the first wire 33a may electrically connect directly the electrode terminal of the optical element 22 and the internal connection section 35a.

An electrode terminal of the driver circuit 32 and the remaining internal connection section 35b are attached together in the electrically-continuous state. The electrode terminal of the driver circuit 32 is electrically connected to the remaining electrode terminal of the optical element 22 by the second wire 33b. This allows the driver circuit 32 to supply an electric signal to the optical element 22, and to drive and control the optical element 22. The driver circuit 32 may be electrically connected to any external device via the external connection section 36b linked to the remaining internal connection section 35b.

The optical element mounting section 34 is provided with a light transmitting section 38 forming an aperture 37 that penetrates through in the thickness direction A. The light traveling over the optical fiber 23 and the optical element 22 travels along a predetermined optical path 80. This light passes through the aperture 37 of the light transmitting section 38. The optical element 22 blocks one end portion 48 of the light transmitting section 38 in its axis direction, and is attached to a surface portion 39 of the optical element mounting section 34 on the side in one thickness direction A1. Herein, the one end portion 48 of the light transmitting section 38 in the axis direction serves as a side end portion of the light transmitting section 38 on the side in one thickness direction A1.

The optical element 22 is provided with an optical surface 41. When the optical element 22 is a light-emitting element, e.g., LED, the optical surface 41 serves as a light-emitting surface. When the optical element 22 is a light-receiving element, e.g., PD, the optical surface 41 serves as a light-receiving surface. The optical surface 41 is directed to the light transmitting section 38 from the side in one thickness direction A1, and is disposed on the extension line of the optical path 80. As such, the optical element 22 is so disposed that the optical surface 41 faces the optical element mounting section 34 of the lead frame 30. Such placement of the optical element 22 and the lead frame 30 is sometimes referred to as face-down placement.

As to the optical element 22 and the driver circuit 32, the sealing body 29 covers the optical element 22 and the driver circuit 32 from a side opposite to the lead frame 30. Accordingly, the sealing body 29 blocks a side of the optical element 22 in one thickness direction A1, and covers the optical element 22 by a side portion of the sealing body 29 in the other thickness direction A2.

The sealing body 29 is at least formed in a region excluding the optical path 80. The sealing body 29 includes an additive that increases the environment resistance of the sealing structure 20. To be more specific, the sealing body 29 is made of a sealing molding resin added with a filler. With the addition of a filler, the sealing body 29 can be set with the linear expansion coefficient and the heat transmission rate.

By making the linear expansion coefficient of the sealing body 29 closer in value to the linear expansion coefficients of to-be-mounted bodies, i.e., the optical element 22, the wires 33a and 33b, and the driver circuit 32, the to-be-mounted bodies 22, 32, 33a, and 33b can be increased in heat shock resistance. Note here that when the to-be-mounted bodies 22, 32, 33a, and 33b have each different linear expansion coefficient, the linear expansion coefficient of the sealing body 29 is optimally set so as to minimize any possible damage of the to-be-mounted bodies 22, 32, 33a, and 33b. For example, the linear expansion coefficient of the sealing body 29 is set to be almost the same as the linear expansion coefficient of the wires 33a and 33b or the optical element 22. The expression of almost the same includes the case where the values are exactly the same. This enables to reduce any possible damage of the to-be-mounted bodies 22, 32, 33a, and 33b. Moreover, by setting large the heat transmission rate of the sealing body 29, the heat dissipation characteristics of the to-be-mounted bodies 22, 32, 33a, and 33b can be increased.

The transmitting body 31 covers a surface portion 47 of the lead frame 30 in the other thickness direction A2. The transmitting body 31 blocks at least the other end portion 49 of the light transmitting section 38 in the axis direction. The transmitting body 31 is of a high light transmittance, and the light transmittance is at least higher than that of the sealing body 29. To the transmitting body 31, a lens portion 42 in the shape of lens is formed on the optical path 80. The lens portion 42 is increased in dimension in the thickness direction toward the center of the optical path 80, and is formed as a so-called convex lens.

When the optical element 22 is a light-receiving element, the lens portion 42 is preferably defined by refractive index and focal distance in such a manner that the light coming from the one end surface 27 of the optical fiber 23 is gathered by the light-receiving surface 41 of the light-receiving element 22. Similarly, when the optical element 22 is a light-emitting element, the lens portion 42 is preferably defined by refractive index and focal distance in such a manner that the dispersion of light coming from the light-emitting surface 42 of the light-emitting element 22 is suppressed, and the amount of light entering the one end surface 27 of the optical fiber 23 is increased.

The optical coupler 21 including such a sealing structure 20 is electrically connected to a control device being an external device of the optical coupler 21. The control device and the optical coupler 21 exchange electric signals with each other.

When the optical element 22 is a light-emitting element, the control device supplies a light emission command to the drive circuit 32 as an electric signal via the external connection section 36b of the lead frame 30. In accordance with thus provided electric signal, the drive circuit 32 makes the light-emitting surface 41 of the light-emitting element 22 emit light.

The light coming from the light-emitting surface 41 travels in the other thickness direction A2. The light goes through the aperture 37 of the light transmitting section 38, and also passes through the transmitting body 31. The light is then gathered by the lens portion 42 of the transmitting body 31, and enters the one end surface 27 of the optical fiber 23. The light thus entered the one end surface 27 of the optical fiber 23 travels inside of the fiber.

As such, the optical coupler 21 can couple together the light-emitting element 22 and the optical fiber 23 to be ready for light transmission, and can supply the electric signal coming from the control device to the optical fiber 23 as an optical signal.

When the optical element 22 is a light-receiving element, the light traveling inside of the fiber exits from the one end surface 27 of the optical fiber 23. The light enters the lens portion 42 of the transmitting body 31, and is gathered by the lens portion 42. The light travels in the transmitting body 31 in one thickness direction A1. The light then goes through the aperture 37 of the transmitting body 38, and enters the light-receiving surface 41 of the light-receiving element 22.

Once the light enters the light-receiving surface 41, the light-receiving element 22 generates an electric signal based on the incoming light, and forwards the resulting electric signal to the drive circuit 32 or the control device. As such, the optical coupler 21 can couple together the light-receiving element 22 and the optical fiber 23 to be ready for light transmission, and can forward the optical signal forwarded to the light-receiving element 22 to the control device as an electric signal.

Here, it is preferable that the light transmitting section 38 is formed to have the wider inner diameter as is away from the optical surface 41, and the inner surface 45 has the high light reflectivity. In other words, it is preferable that the one end portion 48 in the axis direction is formed tapered to have the shorter diameter than the other end portion 49 in the axis direction. That is, the inner surface 45 of the light transmitting section 38 is shaped to be along an outer peripheral surface of a three-dimensional object of conical trapezoid.

Assuming that a light-emitting element is used for the optical element 22, when the dispersion angle of light coming from the light-emitting surface 41 is large, the light is first reflected by the inner surface 45 of the light transmitting section 38, and then is refracted by the lens portion 42 before being directed to the optical fiber 23. Accordingly, even if the optical element 22 is an LED or others having the lager dispersion angle, the light coming from the optical element 22 can be directed to the optical fiber 23 with high efficiency. Assuming also that a light-receiving element is used for the optical element 22, the light directed to the transmitting body 31 is reflected by the inner surface 45 of the light transmitting section 38 so that the light condensing effect can be achieved.

By etching or presswork, the light transmitting section 38 can be formed at the same time as patterning of the lead frame 30. Therefore, there is no need for any new processing process to taper the inner surface of the light transmitting section 38. This enables to manufacture the sealing structure 20 with high light condensing effect with no increase of the manufacturing cost.

As such, the sealing body 29 is disposed in the region excluding the optical path 80. As described in the foregoing, the optical path 80 is a region in which the light travels across the optical element 22 and the optical fiber 23. Therefore, even if the sealing body 29 is colored, the light passing through the aperture 37 of the light transmitting section 38 is not reduced in amount so that the selection options of material for use for the sealing body 29 can be increased. Accordingly, even if the sealing body 29 is added with any colored additive for the purpose of increasing the environmental resistance of the optical element 22, the light transmission rate is not reduced and the environmental resistance can be increased.

When the sealing body is made of an epoxy resin, a filler is added to increase the heat shock resistance and the heat dissipation characteristics. The filler is exemplified by molten silica, crystalline silica, or others. The environmental resistance is also exemplified by the moisture resistance, the heat resistance, the cold resistance, the stable performance characteristics under high temperature, the stable performance characteristics in the state of low temperature, the resin strength enhancement characteristics, the flame resistance, and the coloring characteristics. The substance of increasing any other possible environmental resistance is exemplified by aluminum nitride, alumina, boron nitride, zinc oxide, silicon carbide, and others, and any of these substances may be added. By adding such environmental-resistance-increasing substances to the sealing body, the sealing structure 20 can be increased in environmental resistance without reducing the light transmission rate.

The optical element 22 is disposed on the optical element mounting section 34 with the face-down placement. This enables to easily transfer the heat generated on the optical surface 41 to the optical element mounting section 34, and the heat dissipation characteristics of the optical element 22 can be made better. As a result, the operating temperature of the optical element 22 can be reduced so that the optical element 22 can be stably operated even under the high temperature environment. Moreover, the stresses to be produced in the optical element 22 can be reduced while suppressing the heat expansion of the optical element 22 so that the optical element 22 can be protected from any possible damage.

When an LED is used for the optical element 22, the optical surface 41 serving as an active surface layer of the LED produces heat. The optical element 22 is thus large in heat resistance. Therefore, with the conventional face-up placement, i.e., with the placement in which the surface opposite to the optical surface 41 is attached to the lead frame 30, the heat transmission rate is low from the optical surface 41 to the optical element mounting section 34, and the heat dissipation characteristics are thus poor.

On the other hand, in the invention, with the face-down placement in which the optical element 22 is attached to the lead frame 30, the heat is transferred from the optical surface 41 directly to the lead frame 30 without going through the optical element 22. With such a configuration, the heat dissipation characteristics of the optical element 22 can be made better. Especially when the optical element 22 is made of gallium arsenide (GaAs), the heat resistance is high so that the heat dissipation characteristics of the optical element 22 can be improved to a further degree.

With the face-down placement, a surface portion 46 of the optical element 22 is in contact with the lead frame 30 on a side in the other thickness direction A2. This thus eliminates the need to use the sealing body 29 for sealing the neighboring portion of the optical surface 41. With such a configuration, even if the optical element 22 is small in size, there is no more need to dispose the sealing body 29 in the neighboring portion of the optical surface 41 so that the sealing structure 20 can be manufactured with ease.

When the optical element 22 and the optical element mounting section 34 are electrically connected to each other, for attachment of the optical element 22 and the optical element mounting section 34, it is preferable to use an adhesive material with electrical conductivity for attachment of the optical element 22 to the optical element mounting section 34. This achieves to attach the optical element 22 to the optical element mounting section 34 in one operation while establishing an electrical connection therebetween.

What is more, among any highly-conductive adhesives, using a material of a high thermal conductivity or a thin film material will lead to sufficient heat contact. It is more preferable if the adhesive can absorb any difference between the linear expansion coefficient of the lead frame 30 and that of the optical element 22. For example, such an adhesive material can be implemented by silver paste or solder paste. Alternatively, eutectic gold bonding will do for attachment of the optical element 22 to the optical element mounting section 34.

Moreover, by covering the other end portion 49 of the light transmitting section 38 in the axis direction with the transmitting body 31, the optical surface 41 can be prevented from being exposed. This protects the optical surface 41 from water or impurity, and the moisture resistance of the sealing structure 20 can be thus increased. With the transmitting body 31 formed with the lens portion 42, the light usage efficiency can be made better by the small-sized optical system of simple configuration.

The optical element 22 is exemplified not only by LED and PD but also by CCD, vertical cavity surface emitting laser (VCSEL, Vertical Cavity Surface Emitting Laser), optical integrated circuit (OPIC, Optical Integrated Circuit) carrying therein the optical element 22 and an integrated circuit (IC, Integrated Circuit), and the like. The light wavelength of the optical element 22 is preferably the one leading to a small transmission loss of the optical fiber 23 to be coupled to the optical coupler 21.

The optical fiber 23 for use is preferably a multimode optical fiber such as polymer optical fiber (POF, Polymer Optical Fiber), glass optical fiber (GOF, Glass Optical Fiber), and the like. As to the POF, the core is made of highly-transmissive plastic such as poly methyl methacrylate (PMMA, Poly Methyl Methacrylate), polycarbonate, or others, and the clad is made of plastic whose refractive index is lower than that of the core. Compared with the GOF, the POF is easily increased in its core diameter to be 200 µm or larger but 1 mm or smaller. Therefore, using the POF eases the coupling adjustment with the optical coupler 21, and achieves manufacturing with low cost.

Another option for use is the PCF (Polymer Clad Fiber) in which the core is made of quartz glass, and the clad is made of polymer. Although the PCF is more expensive compared with the POF, but is advantageously small in transmission loss, and wide in transmission band. Accordingly, by using the PCF as a transfer medium, the resulting optical communications network becomes capable of longer-distance communications and higher-speed communications .

For example, the LED for use with the optical communications application is of about a few hundred µm square in element size, and the optical surface 41 has the diameter of about 100 µm. The PD for use with the optical communications application is of about 1 mm square, and the optical surface 41 has the diameter of about a few hundred µm or larger but 1 mm or smaller. Note that the size of the optical surface 41 may vary depending on the communications speed or others,

The lead frame 30 has the thickness of 100 µm or more but 500µm or less. For use as the lead frame 30, used is a thin metal plate made of a metal with high conductivity and thermal conductivity. For example, for use as the lead frame 30, used is copper, copper alloy, iron alloy, e.g., 42 alloy based on iron with 42% of nickel. The lead frame 30 may be plated by silver or gold in order to increase the light reflectivity of the inner surface 45 of the light transmitting section 38.

As described above, the inner surface 45 of the light transmitting section 38 is shaped to be along the outer peripheral surface of a three-dimensional object of conical trapezoid. The small-side diameter being an internal diameter of the one end portion 48 of the light transmitting section 38 in the axis direction is set based on the size of the optical surface 41 of the optical element 22. In a case where the small-side diameter L2 is set too small, when the optical element 22 is displaced in position, the optical surface 41 of the optical element 22 is partially blocked so that the light usage efficiency is reduced. This thus problematically requires to dispose the optical element 22 with high precision. When the small-side diameter L2 is set too large, the light reflected by the inner surface 45 of the light transmitting section 38 is already spread out wide when reflected. Therefore, there are problems of increasing the difficulty for the optical fiber 23 to gather the light, or decreasing the attachment area of the optical element 22 to the optical element mounting section 34 so that the attachment strength becomes not enough.

In consideration of the above, the small-side diameter L2 is set to a value derived by adding the diameter of the optical surface 41 of the optical element 22 with a possible maximum displacement amount based on the predetermined placement precision. For example, when the optical surface 41 has the diameter of 100 µm, and the placement precision of ±20µm, the small-side diameter L2 is set to 120 µm. In this embodiment, the small-side diameter L2 is set to 1.1 times or more but 1.6 times or less of the optical surface 41 so that the above-described problems can be cleared.

The inner diameter of the other end portion 49 of the light transmitting section 38 in the axis direction, i.e., the large-side diameter L3, is determined by the slope angle of the inner surface 45 of the light transmitting section 38. When the optical element 22 is a light-emitting element, the inner surface 38 of the light transmitting section 38 is set to such an angle that the light reflected by the inner surface 45 becomes almost parallel to the optical axis of the optical fiber 23. When this slope angle of the inner surface 45 is too small or too large, the light coming from the light transmitting section 38 resultantly spreads out. More specifically, assuming that the sealing structure is cut along a virtual line including the optical axis, the angle formed by the surface of the lead frame 30 on the side in one thickness direction A1 and the inner surface 45 is preferably set to be 30 degrees or more but 70 degrees or less.

When the optical element 22 is a light-receiving element, the inner surface 38 of the light transmitting section 38 is set to an angle with which the light reflected by the inner surface 45 is gathered on the optical surface of the optical surface 41 of the light-receiving element. When this slope angle of this inner surface 45 is too large or too small, the light amount of the light to be gathered on the optical surface 41 is resultantly reduced. More specifically, assuming that the sealing structure is cut along a virtual line including the optical axis, the angle formed by the surface of the lead frame 30 on the side in one thickness direction A1 and the inner surface 45 is preferably set to be 30 degrees or more but 70 degrees or less.

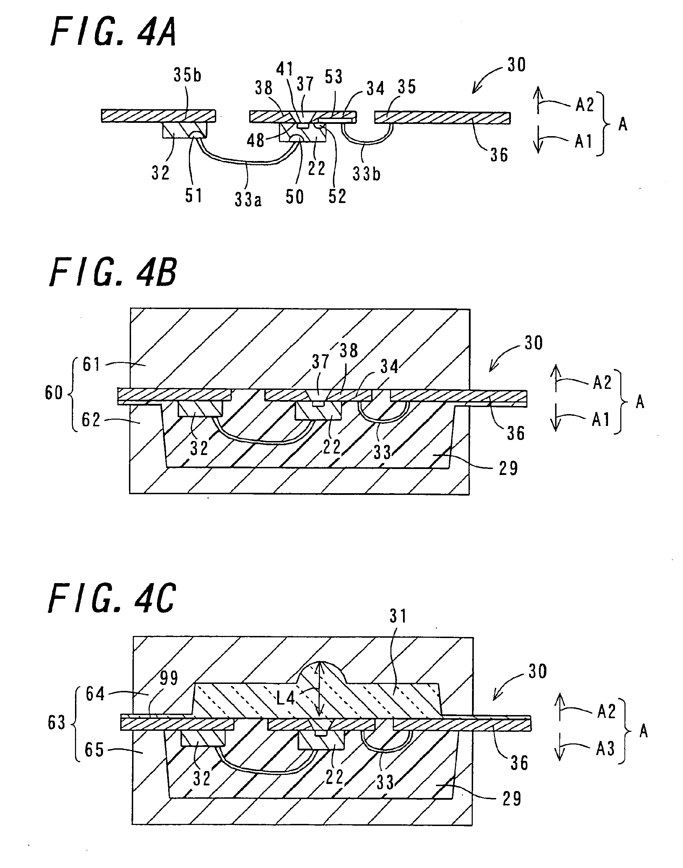

FIG. 3 is a flowchart showing the manufacturing procedure of the sealing structure 20, and FIGS. 4A to 4C are each a diagram showing the manufacturing procedure of the sealing structure 20. First of all, in step s0, after a designing process, e.g., outside shape designing of the sealing structure 20 or wiring pattern designing of the lead frame 30, the procedure goes to step s1, and the sealing structure 20 is started to be manufactured.

in step s1, in accordance with the wiring pattern designed in step s0, the lead frame 30 is formed. The lead frame 30 is formed by etching or presswork. In this manner, the lead frame 30 is formed with the optical element mounting section 34, the internal connection sections 35, the external connection sections 36, and others. At this time, the optical element mounting section 34 is provided with the light transmitting section 38 that penetrates through in the thickness direction A. As such, after the lead frame 30 including the light transmitting section 38 is formed, the procedure goes to step s2.

In step s2, the to-be-mounted bodies 22 and 32 are attached to the lead frame 30 so as to be mounted on the lead frame 30. More specifically, the optical element 22 is die-bonded to the optical element mounting section 34. The drive circuit 32 is die-bonded to its corresponding internal connection section 35b. At this time, the optical surface 41 is so disposed as to direct toward the aperture 37 of the optical element mounting section 34 from the side in one thickness direction A1. Moreover, the optical element 22 is attached to the optical element mounting section 34 in such a manner as to block the one end portion 48 of the light transmitting section 38 in the axis direction.

When the optical element 22 is disposed on the optical element mounting section 34, the optical element 22 is attached to the optical element mounting section 34 using an adhesive material with conductivity. As a result, an electrode terminal 53 of the optical element 22 formed in one thickness direction A2 is electrically connected to another electrode terminal 53 to be formed on the optical element mounting section 34.

Next, using the wires 33, the to-be-mounted bodies 22 and 33 are electrically connected. More specifically, the first wire 33a is used to wire-bond an electrode terminal 50 to be formed on the optical element 22 on the side in the other thickness direction A2, and an electrode terminal 51 to be formed on the driver circuit 32 in the other thickness direction A2. Moreover, the second wire 33b is used to wire-bond the electrode terminal 53 to be formed on the optical element mounting section 34, and the predetermined inner-side connection section 35. As such, as shown in FIG. 4A, after the to-be-mounted bodies 22, 32, and 22 are mounted on the lead frame 30, the procedure goes to step s3.

In step s3, the sealing body 29 is molded using a sealing molding resin. First of all, the lead frame 30 carrying thereon the to-be-mounted bodies 22 and 32 is attached to a sealing body molding mold 60. With the lead frame 30 attached, the sealing body molding mold 60 is formed therein with an internal space closer to one thickness direction A1 than to the lead frame 30. In the sealing body molding mold 60, a first mold portion 61 for the lead frame 30 on the side in the other thickness direction A2 abuts on the entire surface portion of the lead frame 30 on the side in the other thickness direction A2. In the sealing body molding mold 60, a second mold portion 62 for the lead frame 30 on the side in one thickness direction A1 is away from the driver circuit 32, the optical element 22, and the wires 33a and 33b in one thickness direction A1, and thus is never in contact therewith.

Next, as shown in FIG. 4B, a sealing molding resin is filled into the internal space of the sealing body molding mold 60, and the sealing body 29 is formed by the sealing molding resin. This sealing molding resin is including an additive of increasing the environmental resistance. After the sealing body 29 is formed as such, the procedure goes to step s4.

In step s4, the transmitting body 30 is molded using a transmitting molding resin. First of all, the lead frame 30 formed with the sealing body 29 is attached to a transmitting body molding mold 63. With the lead frame 30 attached, the transmitting body molding mold 63 is formed therein with an internal space closer to the other thickness direction A2 than to the lead frame 30. As to the transmitting body molding mold 63, a third mold portion 64 of the lead frame 30 on the side in the other thickness direction A2 is at least being away from the light-transmitting section 38 of the lead frame 30, and thus never blocks the light transmitting section 38. In this embodiment, the transmitting body 31 is formed with a lens portion so that the distance L4 in the thickness direction A between the third mold portion 64 and the lead frame 30 is reduced as being away from the center axis of the light transmitting section 38. As to the transmitting body molding mold 63, a fourth mold portion 65 for the lead frame 30 on the side in one thickness direction A1 is formed with an internal space that can accommodate therein the formed sealing body 29.

Next, as shown in FIG. 4C, the internal space of the transmitting body molding mold 63, i.e., between the third mold portion 64 and the lead frame 30, the transmitting molding resin is filled, and the transmitting body 31 is formed using the transmitting molding resin. In this manner, the aperture 37 of the light transmitting section 38 is also filled with the transmitting molding resin. Such a molding resin is preferably high in light transmittance after molding. After the transmitting body 31 is formed as such, the procedure goes to step s5. In step s5, after the molding resin is subjected to post processing, e.g., burring, the procedure goes to step s6, and this is the end of the manufacturing of the sealing structure 20.

As described in the foregoing, by forming the sealing body 29 and the transmitting body 30 using the molding resin, the sealing structure 20 can be easily formed with low cost. Especially with transfer molding, the sealing structure 20 can be manufactured in volume so that the sealing structure can be manufactured with lower cost. In the present embodiment, after making the optical element 22 block the one end portion 48 of the light transmitting section 38 of the lead frame 30 in the axis direction, the sealing body 29 is molded. In this manner, it becomes able to easily prevent the sealing molding resin from entering the optical surface 41 and the optical path 80.

In the sealing body molding process, the lead frame 30 is deformed, and some dimension error occurs in the mold. Therefore, it is not possible to stop the sealing molding resin from finding its way from the lead frame 30 to the side in the other thickness direction A2. With this being the case, a phenomenon that the sealing molding resin finds its way to the lead frame 30 on the side in the other thickness direction A2 may occur, i.e., flash.

In the present embodiment, as shown in FIG. 1, the optical element mounting section 34 is so formed as to have the separation distance L1 from an edge portion 44 to the light transmitting section 38. This configuration enables to protect the light transmitting section 38 from the sealing molding resin even if flash occurs. Accordingly, the optical path 80 can be protected from blockage by the sealing molding resin without the need for high-precision management for the mold 60 and the lead frame 30.

The separation distance L1 is set to such a value that the sealing molding resin does not enter the light transmitting section 38. When the dimension of the sealing body 29 and the transmitting body 31 in the thickness direction is formed to be of about 1 mm, the separation distance L1 is preferably set to a few hundreds µm or more but a few mm or less, e.g., 200 µm or more but 3 mm or less. With the separation distance L1 being smaller than a few hundreds µm, the sealing molding resin may reach the light transmitting section 38. With the separation distance L1 being exceeding a few mm, there is a problem that the size reduction of the sealing structure 20 becomes difficult.

As such, by setting the distance L1 from the edge portion 44 to the light transmitting section 38 to the separation distance L1, the optical element mounting section 34 becomes able to easily prevent blockage of the optical path as a result of flash. Accordingly, even if used is the optical element 22 small in size such as LED or PD, the sealing body 29 can be formed with ease.

In the sealing body molding process, the mold is provided with some distance away from the to-be-mounted bodies 22, 32, and 33. This reduces the possibility for the mold of coming in contact with the optical element 22 and the wires 33. This thus enables to protect the optical element 22 from any possible damage so that the possibility of defectiveness can be reduced. This also eliminates the need to achieve precisely the precision management of the mold and deformation prevention of the lead frame 30. Accordingly, even if the optical element 22 is small in size, the sealing structure 20 can be manufactured with a simple manufacturing method.

In the present embodiment, in the sealing body molding process, the surface portion of the lead frame 30 in the other thickness direction A2 is made to entirely abut on the internal surface of the first mold portion 61. In this state, the sealing molding resin is filled into the internal space of the mold. Therefore, the first mold portion 61 is not required to be complicated in shape any more. What is more, this can prevent with certainty the sealing molding resin from reaching the light transmitting section 38 and the optical path 80.

The heat-resistance temperature of the transmitting body 31 may be sometimes lower than that of the sealing body 29 to derive high light transmittance. In this embodiment, with the transmitting body molding process after the sealing body molding process, the transmitting molding resin is not heated too much, and thus the molding accuracy can be increased for the transmitting body 31. This enables to form the lens portion 42 which is formed in the transmitting body 31, with precision, so that the light condensing effect can be increased.

What is more, only by adding an additive of increasing the environmental resistance to the sealing molding resin, the environmental resistance of the sealing structure 20 can be increased. Moreover, with the environmental resistance increased as such, the light passing through the light transmitting section 38 is not reduced in amount, and the light transmission rate is not reduced. In other words, the environmental resistance can be made better at the same time as the light transmission rate is retained, and the sealing structure 20 can be increased in quality.

For example, by making the linear expansion coefficient of the sealing body 29 closer in value to the linear expansion coefficient of any of the to-be-mounted bodies 22, 32, and 33, the to-be-mounted bodies 22, 32, 33 can be increased in heat shock resistance. In this manner, any possible damage of the to-be-mounted bodies 22, 32 and 33 can be prevented, and the reliability of the sealing structure can be increased. Moreover, with the sealing body 29 reduced in heat resistance, the heat transmission rate of the sealing structure 20 is increased so that the heat dissipation characteristics can be made better.

When an LED is used for the optical element 22, it is preferable that the aperture 37 of the light transmitting section 38 is filled with a transmitting molding resin having the refractive index higher than that of air, and the transmitting molding resin is molded while being in contact with the light-emitting surface 41. This can improve the external quantum efficiency of the LED, and the light-emitting amount can be made better. The external quantum efficiency is the number of output electrons to be ejected from the LED with respect to the current running through the LED.

When the light transmitting section 38 is formed, it is preferable that a reference hole (not shown) is formed at the same time for use for positioning of the optical element 22, the lens portion 42, and the optical fiber 23. Such a reference hole is used as an assembly reference of the optical coupler 21, and the light transmitting section 38, the optical element 22, and the lens portion 42 are positioned so that the resulting assembly can be performed with high accuracy. When the sealing structure 20 is used for the optical coupler 21, the reference hole can be used as a reference for positioning of the optical fiber 23 and the optical element 22.

At the time of die-bonding of the optical element 22, an adhesive for attaching the optical element 22 to the lead frame 30 is so required as not to attach to the optical surface 41 of the optical element 22. With the technique of photolithography or others, for the surface of the optical element 22, any portion excluding the optical surface 41 is previously formed with a thin film of the adhesive. This protects the optical surface 41 from the adhesive.

For the sealing molding resin for use for the sealing body 29, used is a material including a filler with an epoxy resin or others that are generally used to seal semiconductor elements. As described in the foregoing, the sealing molding resin is so set that the linear expansion coefficient is closer in value to at least either that of the optical element 22 or that of the wires 33, and the thermal conductivity is high. For example, the optical element 22 is made of silicon (Si) or gallium arsenide (GaAs), and the wires 33 are made of gold (Au) or aluminum (Al).

Assuming that the linear expansion coefficient of the optical element 22 is 2.8 × 10⁻⁶/degree, and the linear expansion coefficient of the wires 33 is 14.2 × 10⁻⁶/degree, it is preferable that the linear expansion coefficient of the sealing molding resin is set to 20 × 10⁻⁶/degree or lower. Note here that the linear expansion coefficient of the epoxy resin including no filler is of about 60 × 10⁻⁶/degree. Here, the thermal conductivity of the sealing molding resin is preferably set to 0.6W/m·degree or more. Note that the thermal conductivity of the epoxy resin including no filler is of about 0.2W/m·degree. This thus helps to reduce the stresses to be produced in the optical element 22 and the wires 33 as a result of some temperature change. Moreover, the heat dissipation characteristics can be made better.

The transmitting molding resin for use for the transmitting body 31 is an epoxy resin or others that is optically transparent. Used for the transmitting molding resin is an epoxy resin including no or little filler if allowed.

Here, the expression of optically transparent means including the transmitting characteristics which can pass through the light of wavelength region in use, and the light transmittance thereof is preferably 70% or higher. The transmitting molding resin is so formed as to cover the surface of the lead frame 30 on the side in the other thickness direction A2.

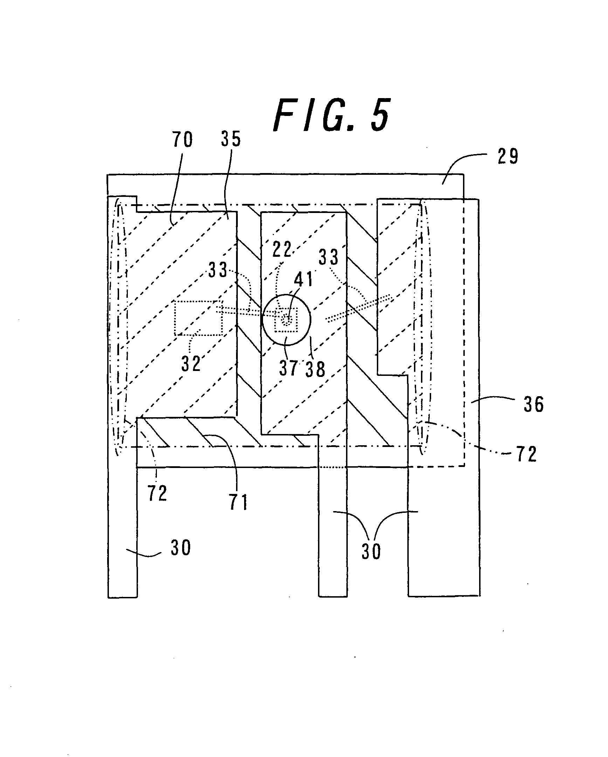

FIG. 5 is a plane view of the sealing structure after formed. Note that, in FIG. 5, the position to be formed with the transmitting body is indicated by double-short dashed lines. The sealing molding resin.is added with a mold release agent to improve the mold releasability between the sealing body molding mold 60 and the sealing body 29 for removing the lead frame 30 from the sealing body molding mold 60 after the sealing body 29 is formed using the sealing molding resin. With this being the case, after the sealing body is formed, the mold release agent seeps on the surface of the sealing body 29.

When the mold release agent seeps on the surface of the sealing body 29, the attachment level between the transmitting body 31 and the sealing body 29 is reduced. In this embodiment, as shown in FIG. 5, the first contact area at which the transmitting body 31 is in contact with the lead frame 30 is set larger than the second contact area at which the transmitting body 31 is in contact with the sealing body 29. Note that, in FIG. 5, the first contact area is hatched by broken lines 70, and the second contact area is hatched by one-dot dashed lines 71. By forming the first contact area larger than the second contact area, the attachment level of the transmitting body 31 can be made better. This thus enables to prevent the transmitting body 31 from falling off from the lead frame 30 and the sealing body 29 due to some temperature change, external forces, or others. This also enables to prevent water from entering the sealing structure as a result of falling off so that the moisture resistance can be made better.

Moreover, because the transmitting body 31 is increased in stresses at the outer peripheral portion, and thus it is preferable that the outer peripheral portion of the transmitting body 31 is so set as to entirely or partially abut on the lead frame 30. For example, assuming that the through-body 31 is cut along a virtual cutting surface vertical to the thickness direction A, when the cut plane is formed rectangular, the end portion of the through-line body 31 on the short side is preferably set to directly abut on the lead frame 30. In FIG. 5, the portion of the lead frame 30 on which the short-side end portion is abutting is indicated by a reference numeral 72.

As such, the sealing structure 20 manufactured by molding is easily manufactured with lower cost compared with the sealing structure using the glass lens. What is better, even if used is the small-sized optical element 22 such as PD or LED, in the resulting sealing structure 20, the optical element 22 and the wires 33 can be sealed by such a simple molding process as using the sealing molding resin high in environmental resistance. Therefore, the sealing structure 20 can be manufactured with low cost with high environmental resistance. Moreover, by the optical coupler 21 including the sealing structure 20 of the present embodiment, the similar effects can be achieved.

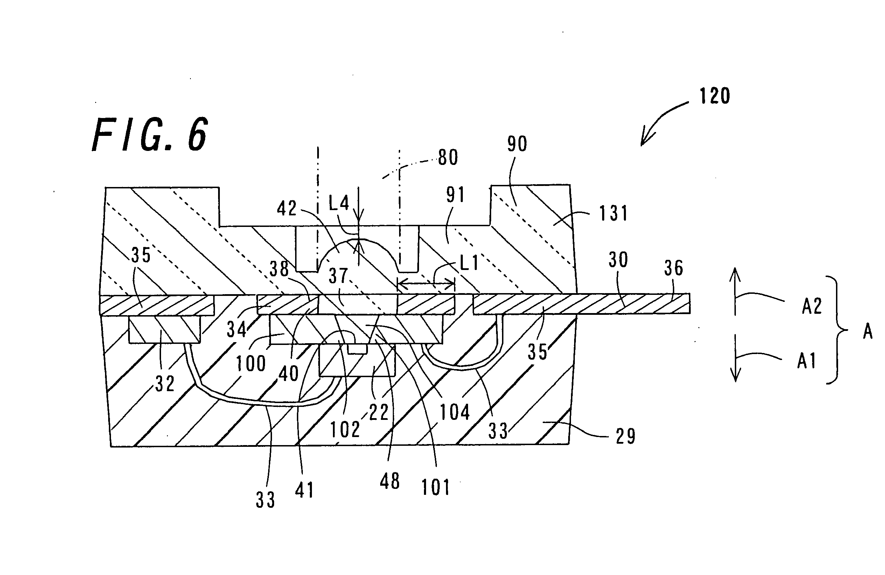

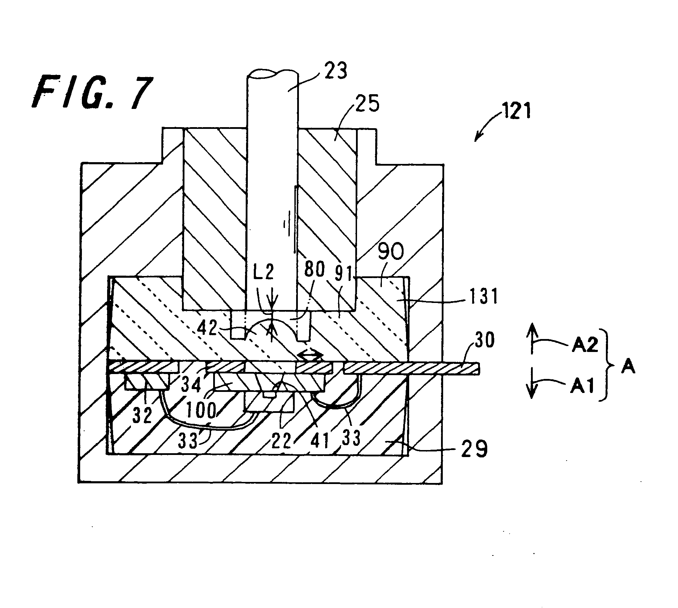

FIG. 6 is a cross sectional view of a sealing structure 120 in a second embodiment of the invention, and FIG. 7 is a cross sectional view of an optical coupler 121 including the sealing structure 120. Compared with the sealing structure 20 of the first embodiment, in the sealing structure 120 of the second embodiment, the transmitting body is different in shape, and the optical element mounting section 34 in the lead frame is different in configuration. The remaining configuration is similar to the configuration of the sealing structure 20 of the first embodiment. Therefore, any configuration of the second sealing structure 120 similar to that of the sealing structure 20 of the first embodiment is provided with the same reference numeral as that of the sealing structure 20 of the first embodiment, and is not described again.

In the sealing structure 120, a sub mount 100 serving as an intermediate body is fixed to the lead frame 30 on the side in one thickness direction A1 of the optical element mounting section 34. Onto the side in one thickness direction A1 of the sub mount 100, the optical element 22 is attached. That is, the sealing structure 120 includes the sub mount 100 between the light transmitting section 38 and the optical element 22. In this embodiment, it is a mounting body including the optical element mounting section 34 of the lead frame 30 and the sub mount 100, and carrying thereon the optical element 22 on the side in one thickness direction A1.

The optical element mounting section 34 is provided with the light transmitting section 38 forming the aperture 37 penetrating through in the thickness direction A. The sub mount 100 is attached onto the surface portion of the optical element mounting section 34 on the side in one thickness direction A1. With this being the case, the sub mount 100 blocks the end portion 48 of the light transmitting section 38 in the axis direction. The sub mount 100 is formed with a light passing section 101 at the position facing the light transmitting section 38. The light passing section 101 is so formed that the light can pass through the sub mount 100. In this embodiment, the light passing section 101 is formed with an aperture 104 penetrating through in the thickness direction. Note that the aperture 37 formed in the light transmitting section 38 is concentrically arranged with respect to the aperture 104 formed in the light passing section 101.

The optical element 22 is attached onto the surface portion of the sub mount 100 on the side in one thickness direction A1. In this case, the optical element 22 blocks a one end portion 102 of the light passing section.101 in the axis direction. The optical element 22 has the optical surface 41 disposed on the extension line of the optical path 80 for the light passing through both the aperture 37 formed in the light transmitting section 38 and the aperture 104 formed in the light passing section 101. In other words, the optical element mounting section 34 and the sub mount 100 are formed with the apertures 37 and 104, respectively, at the position facing the optical surface 41. The aperture 37 formed by the light transmitting section 38 is formed larger than the aperture 104 formed by the light passing section 101 of the sub mount 100.

Similar to the sealing structure 20 of FIG. 1, for the sealing body 29, as to the optical element 22 and the driver circuit 32, the sealing body 29 covers the optical element 22 and the driver circuit 32 from a side opposite to the lead frame 30. Accordingly, the sealing body 29 blocks the side portion of the optical element 22 in one thickness direction A1, and covers the optical element 22 in the side of the sealing body 29 in the other thickness direction A2. The sealing body 29 is at least formed in a region excluding the optical path 80.

The sub mount 100 may be formed with an electrode for electrical coupling with an electrode of the optical element 22, and may be electrically connected to the lead frame 30 and the driver circuit 32 using the wires 33. With this being the case, the electrode terminal of the optical element 22 and that of the drive circuit 32 are attached to the sub mount 100 in the electrically-continuous state. Note here that the lead frame 30 and the sub mount 100 are not necessarily electrically coupled together, and any arbitrary adhesive may be used for attachment.

The sub mount 100 is formed by a silicon substrate, a glass substrate, and the like. When the sub mount 100 is a monocrystalline silicon substrate, the silicon substrate may be subjected to anisotropic etching so that an aperture with the square cross section can be formed in the light passing section 101. More specifically, a potassium hydroxide (KOH) solution is dropped in droplet onto the crystalline surface represented by the mirror index (100) of the monocrystalline silicon for etching. As a result, exposed is the crystalline surface represented by the mirror index (111). By performing etching using a square mask, the resulting inner surface 45 of the light transmitting section 38 is shaped to be along the outer peripheral surface of a three-dimensional object of square cone. In this case, the inner surface 45 of the light transmitting section 38 has four flat surfaces having an angle of 54.74 degree with respect to the crystalline surface represented by (100).

When the light passing section 101 of the sub mount 100 is formed as such, compared with a case where the light transmitting section 38 of the lead frame 30 is formed tapered, the processing precision and the profile accuracy are high. This thus enables the inner surface of the light passing section 101 to serve as a reflective mirror with high performance. Because the silicon is high in thermal conductivity, by forming the sub mount 100 using silicon, the heat produced in the optical element 22 can be removed, and any temperature increase can be suppressed for the optical element 22. When the optical element 22 is implemented by silicon, the difference of the linear expansion coefficient of the sub mount 100 and that of the optical element 22 can be small, and any stresses to be produced in the optical element 22 can be reduced.

Alternatively, the sub mount 100 may be a glass substrate. As the glass substrate being optically transparent, there is no need to separately form the aperture 104 in the light passing section 101 of the sub mount 100. By forming the sub mount 100 using glass whose linear expansion coefficient is close in value to that of the optical element 22, the stresses against the optical element 22 can be reduced. The glass whose linear expansion coefficient is close in value to that of the optical element 22 is exemplified by Pyrex (registered trademark) glass. Alternatively, the light passing section 101 may be formed with a convex lens or Fresnel lens, and a light condensing section may be formed for use for condensing light passing through the optical path 80. With such a configuration, the light usage efficiency of the sealing structure 20 can be increased by the small-sized optical system of simple structure.

By being formed by an optically transparent material, the light passing section 101 of the sub mount 100 can be so disposed as to face the surface of the optical element 22 on a side of the optical surface 41. In this case, there is no need for the transmitting body to seal the light transmittingsection 30 of the lead frame 30. Note that the light transmitting section 30 may be sealed by the transmitting body. Still alternatively, a lens of any arbitrary shape may be directly affixed at the position facing the light transmitting section 38.

Assuming that a PD is used for the optical element 22, when a conductive material, e.g., the lead frame 30, is disposed to face in the vicinity of the optical surface 41, this increases the parasitic capacity of the PD, thereby making difficult to perform a high-speed driving operation. In this embodiment, with the involvement of the insulating sub mount 100 between the lead frame 20 and the optical element 22, the gap with the lead frame 4 is widened. This thus enables to decrease the parasitic capacity of the PD. Further, by reducing the area of an electrode being formed on the sub mount 100 and facing and being connected to the electrode of the optical element 22, the parasitic capacity of the PD can be reduced to a further extent. Moreover, by forming any arbitrary electrode pattern on the sub mount 100, it becomes easy to use an OEIC (integrated circuit including PD, circuit such as amplifier) as the optical element 22.

A transmitting body 131 of the sealing structure 120 of FIG. 6 is formed with a fitting section 90 into which a plug 25 to be fixed to one end portion of the optical fiber 23 is fit. The fitting section 90 is so formed that one end portion of the plug 25 is detachable. The fitting section 90 abuts on an outer peripheral surface of the plug 25, and blocks the plug 25 so as not to move in the direction vertical to the thickness direction A. The transmitting body 131 is formed with a protrusion portion 91 that protrudes toward the optical path from the fitting section 90. The protrusion portion 91 abuts on one end surface of the plug 25 without abutting on one end portion of the optical fiber 23. The protrusion portion 91 blocks the plug 25 so as not to move in one thickness direction A1, and blocks the optical fiber 23 so as not to come into contact with the lens portion 42.

With the plug 25 fitting into the fitting section 90, one end portion of the optical fiber 23 comes in a line with the optical element 22 in the thickness direction. With such a configuration, only by fitting the optical fiber 23 to the fitting section 90, the optical fiber 23 can be guided to the position facing the optical element 22 so that the usability can be increased.

With the fitting section 90 fit to the plug 25, one end portion of the optical fiber 23 is provided with a predetermined gap L4 from the lens portion 42 of the transmitting body 31. This configuration can prevent collision between the optical fiber 23 and the lens portion 42 of the transmitting body 131, and any possible damage of the sealing structure 131 and the optical fiber 23 can be prevented. Herein, the sealing structure 120 of the second embodiment can lead to the effects similar to the sealing structure 20 of the first embodiment. The sealing body 29 and the through-line body 131 configuring the sealing structure 120 of the second embodiment can be formed by molding as is the sealing structure 20 of the first embodiment.

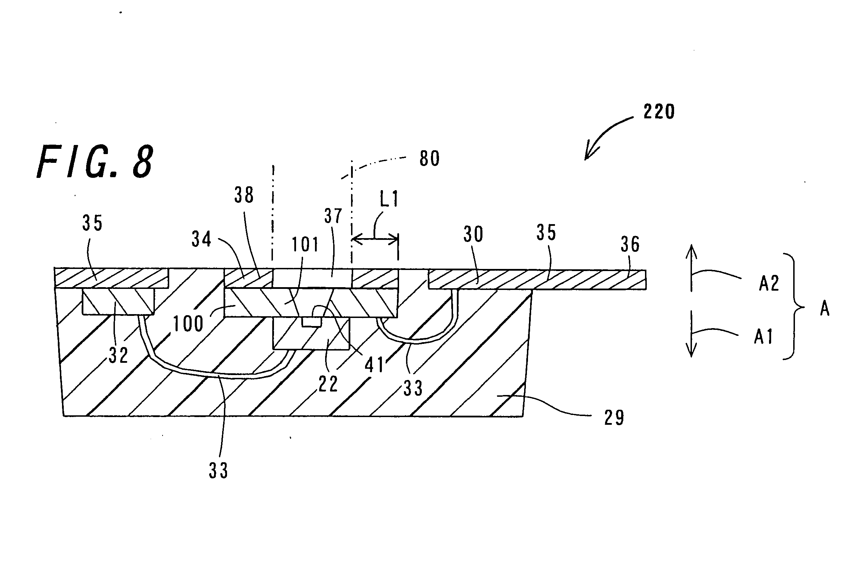

FIG. 8 is a cross sectional view of a sealing structure 220 in a third embodiment of the invention. Compared with the sealing structure 120 of the second embodiment, the sealing structure 220 of the third embodiment has the configuration excluding the transmitting body 131. Therefore, any configuration similar to the sealing structure 220 of the second embodiment is provided with the same reference numeral, and not described again.

In the sealing structure 220, the optical mounting section 34 is connected to the optical element 22 via the sub mount 100. With the configuration excluding the transmitting body 131, the sealing structure 220 can be increased in environmental resistance, and can be manufacture by molding. This enables to manufacture the sealing structure 220 with ease even if the optical element 22 is small in size. Note here that because no transmitting body is formed, the number of manufacturing process can be reduced so that the manufacturing can be achieved with lower cost. Herein, the sealing structure 220 of the third embodiment can lead to effects almost similar to the sealing structure 20 of the first embodiment. Note that the sealing structure 29 configuring the sealing structure 220 of the third embodiment is formed by molding similar to the sealing structure 20 of the first embodiment. In FIG. 8, although the optical element 22 is attached to the lead frame 30 via the sub mount 100, the optical element 22 may be directly attached to the lead frame 30.

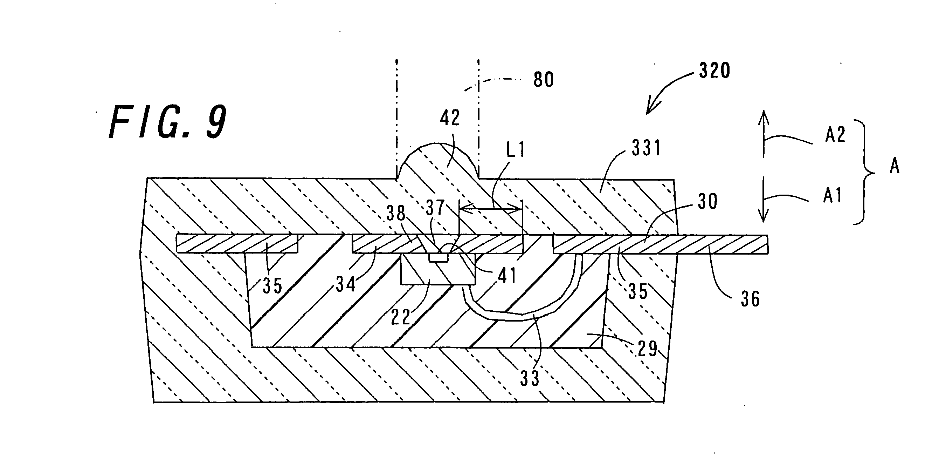

FIG. 9 is a cross sectional view of a sealing structure 320 in a fourth embodiment of the invention. Compared with the sealing structure 20 of the first embodiment, in the sealing structure 320 of the fourth embodiment, the transmitting body is different in shape, and the remaining configuration is similar to that of the sealing structure 20 of the first embodiment. Therefore, any configuration of the fourth sealing structure 320 corresponding to the configuration of the sealing structure 20 of the first embodiment is provided with the same reference numeral as the sealing structure 20 of the first embodiment, and not described again.

As described in the foregoing, in the sealing structure 320 of the fourth embodiment, the sealing body 29 covers the surface portion of the lead frame 30 on the side in one thickness direction A1, the optical element 22, and the wires 33. The sealing structure 320 takes such a configuration that such a covering assembly is covered also with the transmitting body 131. That is, the transmitting body 331 covers, with the transmitting body 331, the components excluding the sealing body 29 and the external connection sections 36 of the lead frame 30. The transmitting body 131 is made of a resin material high in light transmittance characteristics such as epoxy resin, and this resin is used to form the lens portion 42. When the sealing body 29 and the transmitting body 131 are formed by molding, the attachment level is reduced between the sealing body 29 and the transmitting body 131. However, by covering the sealing body 29 with the transmitting body 131, the transmitting body 131 can be prevented from falling off from the sealing body 29. The sealing structure 320 of the fourth embodiment can lead to the effects similar to the sealing structure 20 of the first embodiment. Herein, the sealing body 29 and the transmitting body 331 configuring the sealing structure 320 of the fourth embodiment are formed by molding as is the sealing structure 20 of the first.embodiment.

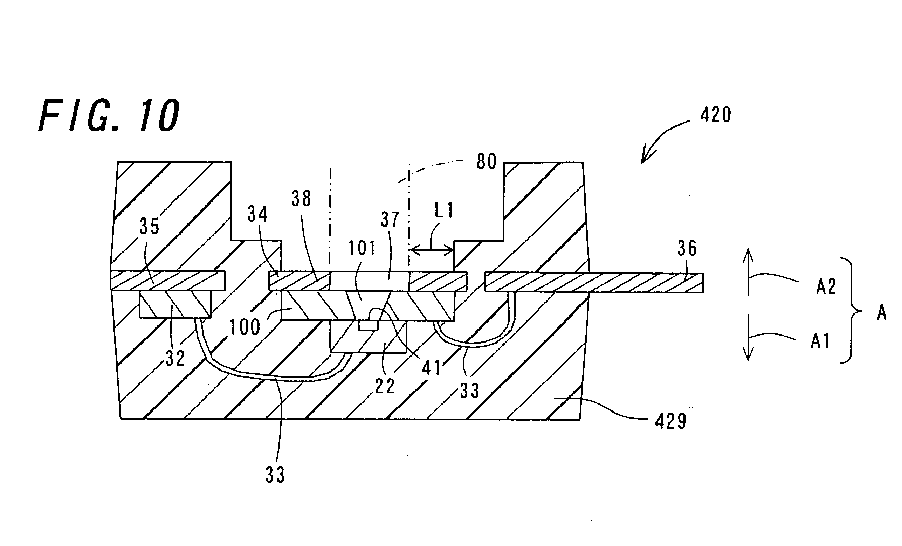

FIG. 10 is a cross sectional view of a sealing structure 420 in a fifth embodiment of the invention. Compared with the sealing structure 220 of the third embodiment, in the fifth sealing structure 420, a sealing body 429 is different in configuration, and the remaining configuration is the same. Therefore, any configuration similar to the sealing structure 220 of the third embodiment is provided with the same reference numeral, and not described again.

The sealing body 429 of the sealing structure 420 covers both sides of the lead frame 30 in the thickness direction. However, the sealing body 429 is disposed in the region excluding the optical path 80. That is, the sealing body 429 covers also the surface of the lead frame 4 in the other thickness direction, except the other end portion of the light transmitting section 38 in the axis direction. In the sealing structure 420 of the fifth embodiment, the sealing body 429 is sandwiching the lead frame 30 from both sides, and the attachment level can be increased between the lead frame 30 and the sealing body 429. Moreover, as the sealing structure 120 of the second embodiment, the sealing body 429 to be formed on the lead frame 30 on the side in the other thickness direction A2 may be partially used for positioning with the optical fiber 23.

The sealing structure 420 of the fifth embodiment can be formed by molding. In this case, as to the lead frame 30 to be attached, in the sealing body molding mold 60, a first mold 61 serving as the side in the other thickness direction A2 forms an internal space between the lead frame 30 and a second mold. In this state, by filling a sealing molding resin into the internal space of the mold, the sealing body 29 is formed. At this time, the first mold portion 61 abuts on the optical element mounting section 34 of the lead frame 30, and the distance from an outer peripheral portion of the abutting portion of the mold portion 61 to the light transmitting section 38 is set to the above-described separation distance L1. This prevents the sealing molding resin from finding its way to the light transmitting section 38. Further, because the optical element 22 never abuts on the first mold portion 61, the optical element 22 can be protected from any possible damage. When the sealing molding resin is prevented from finding its way into the light transmitting section 38, no optical problem will be caused even if any other portion is formed thereby.

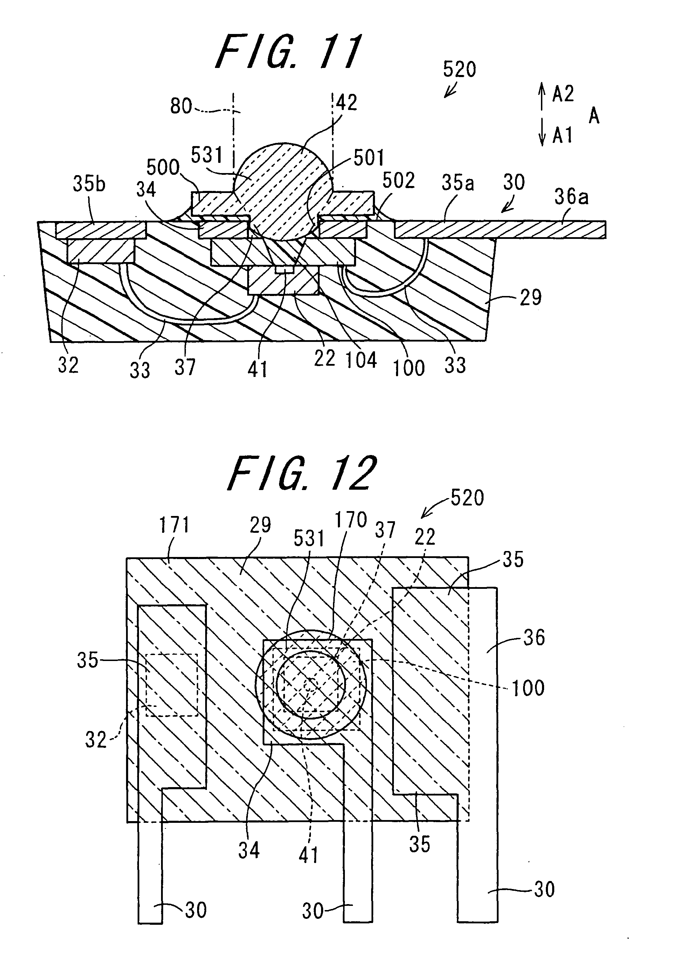

FIG. 11 is a cross sectional view of a sealing structure 520 in a sixth embodiment of the invention. FIG. 12 is a plane view of the sealing structure 520. Compared with the sealing structure 120 of the second embodiment, in the sealing structure 520 of the sixth embodiment, a transmitting body 531 is different in shape, the method of attaching the transmitting body 531 to the optical element mounting section 34, and the manufacturing method thereof are different. The remaining configuration is similar to the sealing structure 120 of the second embodiment. Therefore, any configuration of the sixth sealing structure 520 corresponding to the configuration of the second sealing structure 120 is provided with the same reference numeral as the second sealing structure 120, and not described again.

In the sealing structure 120 of the second embodiment, the sealing body 29 is formed to be a piece with the transmitting body 31 by molding. On the other hand, in the sealing structure 520 of the sixth embodiment, the separately-formed transmitting body 531 is attached to at least either the sealing body 29 or the lead frame 30 using an adhesive 502, and the transmitting body 531 is fixed to the side of the optical element mounting section 34 in one thickness direction A2. In the configuration using such separately-formed transmitting body 531, compared with the case with molding, advantageously, the transmitting body 531 can be easily reduced in size, and the contraction stresses to be produced in molding can be reduced, for example.

As shown in FIG. 12, the transmitting body 531 of the present embodiment is attached onto the optical element mounting section 34, and the sealing body 29 in the vicinity of the optical element mounting section 34. The attachment area at which the transmitting body 531 is in contact with the optical element mounting section 34 and the sealing body 29 is formed smaller than the surface area of the sealing body 29 on the side in the other thickness direction A2, and is formed almost the same as the area of the surface of the optical element mounting section 34 on the side in the other thickness direction. Note that, in FIG. 12, the attachment area of the transmitting body 531 is hatched by broken lines 170, and the surface area of the sealing body 29 in the other thickness direction A2 is hatched by one-dot dashed lines 171.

In the present embodiment, the transmitting body 531 is facing the optical element mounting section 34, and is disposed to be away from the internal connection sections 35. The transmitting body 531 is so formed that no portion is attached to the sealing body 29, or if attached, the portion is formed as little as possible. That is, as to the transmitting body 531, most of the attachment surface is attached to the optical element mounting section 34.

The light transmitting characteristics of the transmitting body 531 are higher than those of the sealing body 29. The transmitting body 531 is configured to include an attachment section 500, the lens portion 42, and a positioning section 501. The attachment section 500 is formed like a plate, and is so disposed as to face the optical element mounting section 34. The attachment section 500 is formed larger than the aperture 37 of the optical element mounting section 34, and covers the aperture 37 from the side in the other thickness direction A2. In this embodiment, the attachment section 500 is formed like a circular plate, and is concentrically arranged about the center of the optical path 80. The transmitting body 531 is formed by injection molding.

The lens portion 42 is linked to the attachment section 500 in the other thickness direction A2, and protrudes from the attachment section 500 in the other thickness direction A2. The lens portion 42 is formed on the optical path 80, and is formed like a convex lens toward the other thickness direction A2. With the positioning section 501 formed like a lens, the light condensing effect can be made better.

The positioning section 501 is linked to the attachment section 500 in one thickness direction A1, and protrudes from the attachment section 500 in one thickness direction A1. With the transmitting body 531 attached, the positioning section 501 is fit into the aperture 37 of the optical element mounting section 34. The outer peripheral surface of the positioning section 501 is sloped to one thickness direction toward the axis of the aperture 37. In other words, the positioning section 501 is formed in a tapered shape to have the shorter diameter toward one thickness direction A1. In this embodiment, the positioning section 501 is formed like a convex lens that is protruding toward one thickness direction A1. The lens portion 42 and the positioning section 501 are concentrically arranged about their axes in the thickness direction. With such a configuration, with the positioning section 501 fit into the aperture 37 of the optical element mounting section 34, the positioning section 501 and the lens portion 42 are concentrically arranged about the center of the optical path 80.

The transmitting body 531 is fixed using the adhesive 502 after the positioning section 501 is positioned at the aperture 37 of the optical element mounting section 34 or at the aperture 104 of the sub mount 100. The adhesive 502 is provided with the light transmitting characteristics, and with higher refractive index than that of air. The adhesive 50 covers the optical surface 41 of the optical element 22, and is filled into a space between the optical surface 41 and the transmitting body 531.

The transmitting body 531 is exemplified by the one formed in any arbitrary shape by injection molding or others, using a light transmitting resin material including poly methyl methacrylate (Poly Methyl Methacrylate, PMMA for short), polycarbonate, or others, or a light transmitting inorganic material including glass.

The adhesive 502 is preferably high in light transmittance characteristics, and has the light refractive index closer in value to that of the transmitting body 531. The adhesive 502 preferably has the viscosity of 0.1Pa·s or more or 10Pa·s or less, and the Young's modulus of 3 MPa or less. For example, the adhesive 502 can be exemplified for use by epoxy resin, silicone resin, and others. Especially because silicone resin is low in Young's modulus, even if the sealing structure 520 is changed in shape due to some environmental temperature change, the adhesive 502 can reduce any stresses acting on the optical surface 41 of the optical element 22 so that the adhesive 502 serves more suitably.

Similarly to the sealing structure 20 of FIG. 1, as to the optical element 22 and the driver circuit 32, the sealing body 29 covers the optical element 22 and the driver circuit 32 from the side opposite to the lead frame 30. Accordingly, the sealing body 29 blocks the side portion of the optical element 22 in one thickness direction A1, and covers the optical element 22 in the side of the sealing body 29 in the other thickness direction A2. The sealing body 29 is formed at least in a region excluding the optical path 80.

The attachment area (region hatched by the broken lines 170 of FIG. 12) at which the transmitting body 531 is attached to the optical element mounting section 34 and the sealing body 29 is formed smaller than the surface area (region hatched by the one-dot dashed lines 171) of the sealing body 29 on the side in the other thickness direction A2. Most of the surface of the lead frame 30 on the side in the other thickness direction A2 is not covered with the transmitting body 531, and is exposed to the air, i.e., into the atmosphere around the sealing structure 520. Note here that the attachment area at which the transmitting body 531 is in contact with the optical element mounting section 34 and the sealing body 29 is preferably formed to be 1/3 or less with respect to the surface area of the sealing body 29 on the side in the other thickness direction A2.

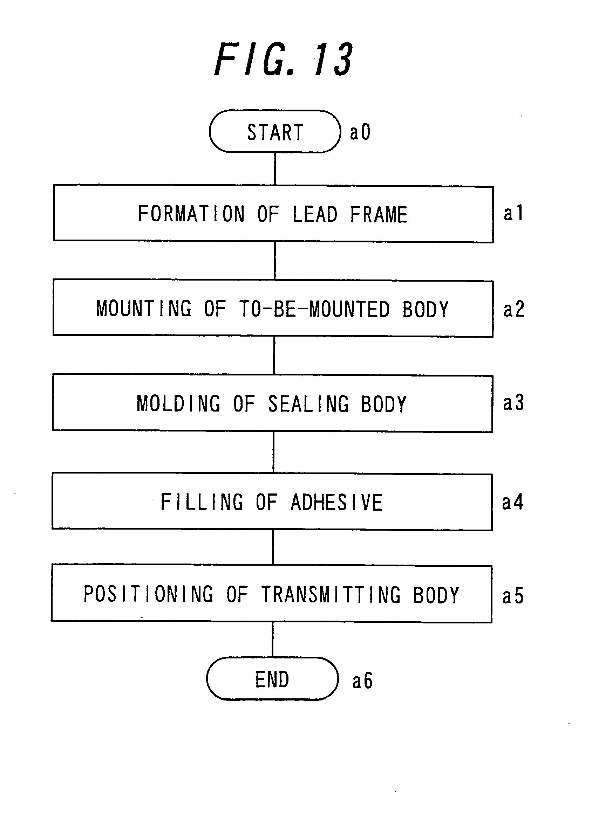

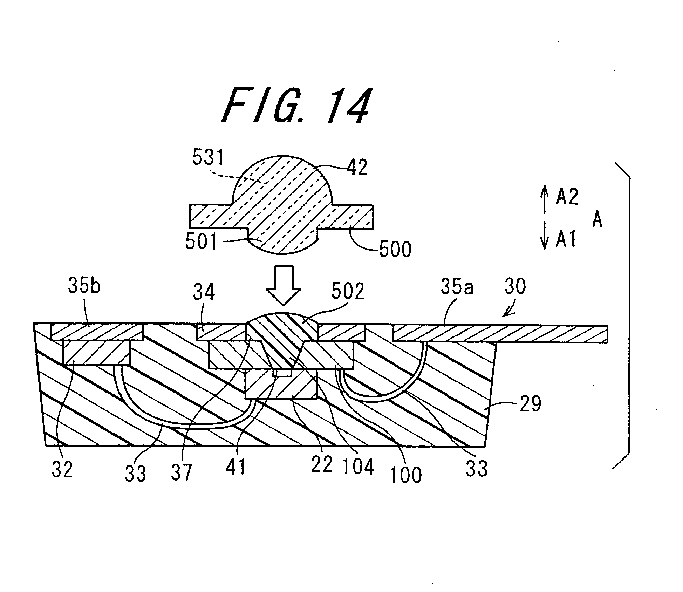

FIG. 13 is a flowchart showing the manufacturing procedure of the sealing structure 520 of the sixth embodiment. FIG. 14 is a cross sectional view for illustrating the manufacturing procedure of the sealing structure 520. First of all, in step a0, after a designing process, e.g., outer diameter designing of the sealing structure 520, or wiring pattern designing of the lead frame 30, the procedure goes to step a1, and the sealing structure 520 is started to be manufactured.

In the manufacturing process, the procedure goes through steps a1 to a3 in order. Note here that steps a1 to a3 are similar to steps s1 to s3 of FIG. 3, and thus are not described again. When the sealing body 29 is completely molded in step a3, the procedure goes to step a4.

In step a4, using a dispenser or others, the adhesive 502 is filled into the aperture 37 of the optical element mounting section 34 and the aperture 104 of the sub mount 100. Once the adhesive 502 is through with filling thereinto, the procedure goes to step a5. In step a5, the transmitting body 531 formed in the process different from the molding process for the sealing body 29 is attached to the optical element mounting section 34. As described in the foregoing, the transmitting body 531 is formed separately from the sealing body 29 by injection molding or others.

In step a5, as shown in FIG. 14, the transmitting body 531 is moved from the side of the other thickness direction A2 toward the side of one thickness direction A1, and the positioning section 501 is inserted into the aperture 37 of the optical element mounting section 34. The adhesive 502 filled into the aperture 37 of the optical element mounting section 34 and the aperture 104 of the sub mount 100 is partially pushed out by the tapered outer peripheral portion of the lens positioning section 501, and is spilled over from the aperture 37 of the optical element mounting section 34 to the side of the other thickness direction A2 of the optical element mounting section 34. As a result, with the transmitting body 531 pushed into the optical element mounting section 34, as shown in FIG. 11, the adhesive 502 is filled between the surface of the transmitting body 531 on the side in one thickness direction A1 and the surface of the optical element mounting section 34 on the side in the other thickness direction A2. When the adhesive 502 is cured in this state, the procedure goes to step a6. In step a6, the manufacturing process is ended, and the sealing structure 520 is completed.

As described above, according to the sealing structure 520 of the sixth embodiment, similarly to the sealing structures 20, 120, 320, and 420 of the above-described embodiments, the optical element 22 is attached to the optical element mounting section 34 with the face-down placement. This enables to ease the wire bonding with an electrode to be formed in the vicinity of the optical surface 5 and the lead frame 30. Furthermore, the transmitting body 531 can have the higher degree of flexibility in terms of shape so that the lens design achieving optical effects can be easily made. What is more, by molding the transmitting body 531 by injection molding, the resulting transmitting body 531 can have the minute lens shape. Also, with the transmitting body 531 formed with the positioning section 501, the positioning and attachment of the transmitting body 531 can be easily done.

In the sealing structure 520 of the sixth embodiment, the transmitting body 531 that is not molded together with the sealing body 29 but is separately formed is attached to the optical element mounting section 34 using the adhesive 502. With this being the case, compared with a case where the transmitting body 531 is formed on the optical element mounting section 34 by molding, the downsizing can be easily achieved. Also compared with the sealing structure 520 of the second embodiment, the frequency of molding can be reduced so that the contraction stresses to be applied at the time of molding with respect to the sealing body 29 and the optical element mounting section 34 can be advantageously reduced.

In the sealing structure 120 of the second embodiment, for example, the transmitting body 131 is formed by transfer molding. With this being the case, as shown in FIG. 4(3), there needs to keep a region 99 in which a transmitting molding resin is filled. As shown in FIG. 12, there thus is a difficulty in disposing the transmitting bodies 31 and 131 like an island with respect to the lead frame 30. Moreover, the transmitting molding resin is easily melted, and thus causes a difficulty in forming the lead frame 30 with an exposure surface for exposure to the air.

On the other hand, in the sealing structure 520 of the sixth embodiment, the transmitting body 531 can be disposed like an island without making the transmitting body 531 come into contact with the surface edge of the sealing body 29 on the side in the other thickness direction A2 so that the transmitting body 531 can be reduced in size. By reducing the size of the transmitting body 531 as such, the lead frame 30 can be easily formed on its surface with an exposure surface that exposes to the air.

By reducing the size of the transmitting body 531, the sealing structure 520 is prevented from being deformed as a result of some environmental temperature change, and even if deformed, any stresses are prevented from being produced in the transmitting body 531. The transmitting body 531 is thus protected from cracking, distortion, and stripping as a result of some environmental temperature change. More specifically, with the sealing structure 20 of the first embodiment of FIG. 1, because the contact area for the sealing body 29 and the transmitting body 31 is large, and because their linear expansion coefficients are different, some environmental temperature change easily causes distortion. However, with the sealing structure 520 of the sixth embodiment of FIGS. 11 and 12, such a deformation possibility can be reduced.

Moreover, with transfer molding, a thermosetting resin is generally used. If this is the case, stresses are produced in room temperature due to contraction at the time of curing, and a difference of the linear expansion coefficient of the transmitting body 3 and that of any other components such as the lead frame 30 and the sealing body 29. For example, when the transmitting bodies 31 and 131 are formed using a transmitting molding resin with the curing temperature of 150 degrees, when it is cured at 150 degrees, the lead frame 30 and the sealing body 29 are deformed as a result of the different linear expansion coefficient, and shape asymmetry. When the transmitting bodies 31 and 131 are formed in this state, in the room temperature, due to the different linear expansion coefficient between any other components such as the lead frame 30 and the transmitting bodies 31 and 131, the transmitting body 31 suffers from large stresses due to the difference between the temperature at molding, i.e., 150 degrees, and the room temperature. Therefore, this easily causes the transmitting body 31 to be deformed, cracked, and stripped from the lead frame 30, thereby causing problems in terms of reliability and characteristics.

On the other hand, in the transmitting body 531 of the sixth embodiment, used is the separately-molded transmitting body 531 so that any effects of thermal stresses between any other components such as the lead frame 30 and the transmitting body 531 can be reduced, thereby leading to the higher reliability. Moreover, by manufacturing the transmitting body 531 by injection molding, this allows to mold the transmitting body 531 using a thermoplastic resin so that any possible stresses after molding can be reduced to a further degree.

What is more, by the positioning section 501 of the transmitting body 531 fitting into the aperture 37 of the optical element mounting section 34, the transmitting body 531 is positioned. As such, by directly positioning the transmitting body 531, it becomes possible to easily position the optical surface 41 of the optical element 22 and the lens portion 42 of the transmitting body 531 with high precision. Note that, in this embodiment, the positioning section 501 is fit into the aperture 37. Alternatively, a positioning hole may be formed separately from the aperture 37 for positioning of the positioning section 501 to the optical element mounting section 34 or the sealing body 29. With the positioning section 501 fit into the positioning hole, the transmitting body 531 is positioned on the optical element mounting section 34. In this case, there is no need to form the positioning section 501 at the position facing the aperture 37.

Also in this embodiment, the transmitting body 531 is formed with a convex portion for use as the positioning section 501. Alternatively, the convex portion may be formed in the optical element mounting section 34 or the sealing body 29, and the transmitting body 531 may be formed with a concave portion. In this case, the convex portion formed in the optical element mounting section 34 or the sealing body 29 is fit into the concave portion formed in the transmitting body 531 so that, similarly to the case described above, the transmitting body 531 can be positioned with the optical element mounting section 34.

Moreover, at the time of positioning between the transmitting body 531 and the optical element mounting section 34, the adhesive 502 is spilled over the aperture 37 of the optical element mounting section 34 and the aperture 104 of the sub mount 100 so that the adhesive 502 can be uniformly disposed between the transmitting body 531 and the optical element mounting section 34. Moreover, the positioning section 501 is formed tapered so that the apertures 37 and 104 can be free from air bubbles. The taper slope angle, the shape, the size, and others of the positioning section 501 can be optimized at any arbitrary taper slope angle, shape, and size based on the amount of the adhesive 502 spilled over the apertures 34 and 104.

The adhesive 502 is injected to cover the optical surface 41 of the optical element 22, and to fill the aperture 37 (the light transmitting section 38) of the optical element mounting section 34, and the aperture 104 (light transmitting section 101) of the sub mount 100. The adhesive 502 is in contact with the transmitting body 531. When an LED is used for the optical element 22, the surface of the optical surface 41 is covered with the adhesive 502 so that the external quantum efficiency can be made better as described above. Moreover, by using the adhesive 502 whose refractive index is almost the same as that of the transmitting body 531, the aperture 37 of the optical element mounting section 34 and the aperture 104 of the sub mount 100 are filled so that the light usage efficiency is prevented from being lowered even with Fresnel reflection.

Moreover, for the adhesive 502, any arbitrary material can be selected depending on its use target, and generally, the adhesion strength can be stronger than that between the lead frame 30 and a transparent resin used in transfer molding. This enables to protect the transmitting body 531 from falling off from the optical element mounting section 34, or prevent the adhesive 502 from being peeled off from the optical surface 41 so that the resulting sealing structure 520 can be high in reliability.

Moreover, because the transmitting body 531 can be reduced in size, the area of the transmitting body 531 covering the lead frame 30 can be also reduced. This enables to expose in the air the surface of the lead frame 30 partially in the other thickness direction A2. By increasing the exposing area of the lead frame 30 as such, the heat dissipation characteristics of the sealing structure 520 can be made better. If this is the case, even if the transmitting body 531 is low in thermal conductivity, the thermal dissipation characteristics are not reduced by the lead frame 30. What is more, by connecting the exposing portion of the lead frame 30 to cooling means, e.g., heatsink, the thermal dissipation can be performed with more efficiency so that the operation under the high temperature is enabled.

The sealing body 29 may be formed also on the lead frame 30 on the side in one thickness direction A2. For example, the fitting section 90 of FIGS. 6 and 7 may be formed by the sealing body 29. In this case, the sealing body 29 may not be formed on a portion where the transmitting body 531 is to be disposed, and a part of the sealing body 29 and the outer peripheral portion of the adhesive section 500 of the transmitting body 531 can be used for positioning. Such a configuration eases the positioning with the optical fiber 23, and the strength can be increased for the sealing structure 520.

Note here that the sealing structures of the above-described embodiments are no more than examples of the invention, and their configurations can be changed without departing from the scope of the invention. For example, although the sealing structures 20, 120, 220, 320, 420, and 520 are described to be used for the optical coupler 21, any other device will also do. The optical element 22 may not be restricted to the elements exemplified in the above. Although the sealing body 29 is preferably formed by molding, the sealing structure may be manufactured by any other manufacturing method. The sealing body 29 does not necessarily cover the optical element 22 in its entirety.

The lead frame 30 denotes a thin metal plate serving to mount thereon the to-be-mounted bodies such as the optical element 22 and the driver circuit 32 for support, and to transfer electricity to the to-be-mounted bodies. In the invention, as an alternative to the lead frame 30, various types of substrates such as stem or printed circuit board are to be used to manufacture the sealing structure 20 with the optical element 22 carried thereon. The light transmitting section 38 is exemplified by being formed with the aperture 37, but it may have the light transmitting characteristics that allows passing of light. The lens portion 42 is formed like a convex lens, but it may be formed to take any other shape, e.g., concave lens. As described above, the transmitting body may be formed by transfer molding as shown in FIG. 3, and be fixed to the optical element mounting section 34, or as shown in FIG. 13, may be attached to the optical element mounting section 34 using the adhesive 502.

The invention may be embodied in other specific forms without departing from the spirit or essential characteristics thereof. The present embodiments are therefore to be considered in all respects as illustrative and not restrictive, the scope of the invention being indicated by the appended claims rather than by the foregoing description and all changes which come within the meaning and the range of equivalency of the claims are therefore intended to be embraced therein.

### Industrial Applicability

According to the invention, even if any colored sealing body is used, the light passing through the light transmitting section is not reduced in amount so that the selection options for the sealing body can be increased. For example, selected may be a sealing body with which the optical element hardly suffers from damage. Moreover, the optical surface is disposed facing the mounting body so that the heat produced by the optical surface becomes easily transferred to the mounting body, thereby increasing the heat dissipation characteristics of the optical element. This accordingly reduces any possible damage of the optical element. In the optical element, the optical surface and the portion in the vicinity of the optical surface are in contact with the mounting body. This thus eliminates the need to use a sealing body to seal the optical element, i.e., the optical surface and the portion in the vicinity of the optical surface. Accordingly, even if the optical element is small in size, the manufacturing can be easily through.

As a sealing body, a molding resin may be used to manufacture a sealing structure by molding. In this case, the optical element is used to block one end portion of the light transmitting section of the mounting body in the axis direction, and then the molding process is executed using the molding resin. In this manner, the molding resin is preventing from finding its way into the optical surface and the optical path. Further, the molding process is executed using a molding resin to cover the portion of the optical element excluding the surface portion facing the mounting body. This eliminates the need to make the optical element come into contact with the mold. This protects the optical element from any possible damage expected at the time of molding without the need for high-precision management for the mold so that the possibility of defectiveness can be reduced and the molding process becomes easy. Especially because there is no need to make the mold contact with the optical element, even if the optical element is small in size, the sealing structure can be manufactured using any simple manufacturing method.

Moreover, according to the invention, even if the sealing body is added with any colored additive for the purpose of increasing the environmental resistance, the light transmission rate is not reduced. Accordingly, the optical transmission rate can be retained while the environmental resistance being increased so that the quality can be improved.

According to the invention, without reducing the light transmission rate, any stresses possibly produced in the optical element or wires can be reduced. This enables to protect the optical element or wires from any possible damage while the light transmission rate being retained so that the reliability of the sealing structure can be increased.

According to the invention, when the sealing body is formed by molding, the surface portion of the mounting body located opposite to the optical element can be entirely made to come into contact with the internal surface of the mold, so that the mold is not required to be complicated in shape any more. Accordingly, the sealing body can be formed with ease. The molding resin is prevented from finding its way into the surface portion of the mounting body opposite to the optical element so that the optical path can be protected from the molding resin.

Moreover, according to the invention, by preventing the optical surface from exposing, the optical surface can be protected from water and impurity. As such, by preventing any water from finding its way into the optical surface, the moisture resistance of the sealing structure can be increased.

According to the invention, by forming the sealing body and the transmitting body using the molding resin, the sealing structure can be easily manufactured with low cost. Especially with transfer molding, the sealing structure can be manufactured in volume so that the sealing structure can be manufactured with lower cost.

According to the invention, the first contact area is formed larger than the second contact area so that the attachment level can be increased among the transmitting body, the mounting body, and the sealing body. This thus enables to prevent the transmitting body from falling off from the mounting body and the sealing body due to some temperature change and external forces. This also enables to prevent water from entering the sealing structure even as a result of falling off so that the moisture resistance can be made better.

According to the invention, the outer peripheral portion of the transmitting body is at least partially in contact with the mounting body. This enables to prevent the transmitting body from falling off from the mounting body and the sealing body when any stresses are produced. This also enables to prevent water from entering the sealing structure as a result of falling off so that the moisture resistance can be made better.

Assuming that the transmitting body is cut along a virtual cutting surface vertical to the light traveling direction, when the cut plane is formed rectangular, the end portion of the transmitting body on the short side is preferably made to directly come into contact with the mounting body. This enables to make the transmitting body especially at a portion where stress concentration trends to occur come into contact with the mounting body, thereby preventing the transmitting body from falling off. In other words, any portion of the transmitting body where stress concentration occurs is preferably made to come into contact with the sealing body.

According to the invention, by covering the sealing body and the mounting body with the transmitting body, the transmitting body can be prevented from falling off from the sealing body and the mounting body with certainty. Moreover, even if the transmitting body falls off, the sealing structure is protected from water so that the moisture resistance can be made better.

According to the invention, the transmitting body is attached to at least either the mounting body or the sealing body using an adhesive. Compared with the case of forming the transmitting body by transfer molding, the resulting transmitting body can be reduced in size. When such downsized transmitting body causes the sealing structure to be heat-deformed due to some environmental temperature change, any possible stresses to be produced in the transmitting body can be reduced so that the resulting sealing structure can be high in reliability. For the adhesive, any arbitrary material can be selected depending on its use target, and generally the adhesion strength can be stronger than that between the transmitting body and the mounting body used in transfer molding. This enables to protect the transmitting body from falling off from the mounting body so that the resulting sealing structure can be high in reliability.

According to the invention, by covering the optical surface of the optical element with an adhesive having the refractive index higher than that of air, when an LED is used for the optical element, it becomes possible to increase the external quantum efficiency. Moreover, it is preferable if used is the adhesive whose refractive index is almost the same as that of the transmitting body, and if the adhesive is filled between the optical surface and the transmitting body. In this manner, the light usage efficiency can be prevented from being lowered as a result of Fresnel reflection.

According to the invention, the optical surface and the transmitting body can be positioned with high precision. As a result, even if the transmitting body is formed smaller than the mounting body, no misalignment is caused, and it is possible to attach the transmitting body to the mounting body with ease.

According to the invention, by fitting the positioning section of the transmitting body to the through hole of the mounting body, it becomes possible to position the transmitting body on the mounting body with ease. Also with assembly in which the adhesive filled into the through hole of the mounting body is as if being pushed aside, the adhesive can be uniformly disposed uniformly between the transmitting body and the mounting body. What is more, the adhesive can be free from air bubbles.

According to the invention, on the surface of the mounting body on the side attached to the transmitting body, an exposure surface exposing in the atmosphere around the sealing structure can be formed so that the heat dissipation characteristics of the sealing structure can be made better.

According to the invention, by bending the light traveling along the optical path using the lens portion, the light usage efficiency can be increased using the small-sized optical system of simple configuration.

According to the invention, by the involvement of the sub mount, it can solve any problem that is to be caused when the optical element is mounted directly on the lead frame. For example, when there is a large difference between the linear expansion coefficient of the lead frame and that of the optical element, the stresses of the optical element as a result of some temperature change can be reduced by making the linear expansion coefficient of the sub mount closer in value to that of the optical element.

Using the sub mount can provide special capabilities. For example, the sub mount may be implemented by a light transmitting material, and if so, the optical surface is prevented from being exposed. Alternatively, the sub mount may be formed with a lens, and if so, the light usage efficiency can be increased. Still alternatively, an electrode may be formed to establish an electrical coupling with an electrode of the optical element, and if so, there is no more need to use any special optical element.

According to the invention, by bending the light traveling along the optical path by the light condensing section of the mounting body, the light usage efficiency can be increased using the small-sized optical system of simple configuration.

According to the invention, to derive the light condensing function, there only needs to form an aperture whose diameter is increased as the inner diameter is away from the optical surface to the light transmitting section. The light transmitting section is formed by etching or presswork, i.e., can be formed at the same time as patterning of the lead frame, and requires no specific new process. This enables to provide the sealing structure with the light condensing function at lower cost without increasing the price.

According to the invention, by forming an exposure surface on the mounting body that is not covered with the transmitting body, the resulting exposure surface can dissipate the heat so that the heat dissipation characteristics of the sealing structure can be made better. Moreover, it is preferable if the exposure surface is connected to a radiator, i.e., heatsink. The heat dissipation can be thus performed with more efficiency so that the operation under the high temperature is enabled.

According to the invention, even if the optical element is a small-sized element being any one of a light-emitting diode, a semiconductor laser, and a photo diode, the optical element can be sealed by the sealing body in a state where the optical element is mounted on the mounting body.

According to the invention, by the optical coupler including the above-described sealing structure, the resulting optical coupler can have good environmental resistance, and can be reduced in size.

According to the invention, after a light transmitting section is formed by the light transmitting section formation step, an optical element is mounted on the mounting body in such a state that the light transmitting section is blocked by the optical element at its one end portion in the axis direction. Next, a sealing molding resin is filled into the mold so that the sealing body is formed. This can prevent the sealing molding resin from finding its way to the optical surface and therearound. Alternatively, by forming the sealing molding resin in the area excluding the optical path, a colored sealing molding resin including the additive for increasing the environmental resistance may be used to seal the optical element to prevent the light transmission rate from being reduced.

When the optical element is sealed by the sealing body, there only needs to inject a sealing molding resin in such a manner as to cover around the optical element mounted on the mounting body, and the mold is not required to be in contact with the optical surface of the optical element. This eliminates the need to manage the mold with high precision. What is more, the optical element can be protected from any possible damage. As such, even if the optical element is small in size, the sealing body can seal the optical element with ease.

## Claims

1. An optical element sealing structure comprising:
a mounting body provided with a light transmitting section through which light traveling along a predetermined optical path passes;
an optical element having an optical surface receiving or emitting light which is directed to the light transmitting section, and is mounted on the mounting body in such a state that the optical element blocks the light transmitting section at one end portion in an axis direction thereof; and
a sealing body that is formed in a region excluding the optical path, and seals the optical element mounted on the mounting body.

2. The optical element sealing structure of claim 1, wherein a material that can increase the environmental resistance of the optical element is added to the sealing body.

3. The optical element sealing structure of claim 1 or 2, further comprising:
a connection body for establishing an electrical connection to the optical element; and
a wire for establishing an electrical connection between the optical element and the connection body,
wherein a linear expansion coefficient of the sealing body is set to be almost equal to a linear expansion coefficient of the wire or the optical element.

4. The optical element sealing structure of any one of claims 1 to 3, wherein the sealing body is formed in a region of the optical element opposite to the mounting body.

5. The optical element sealing structure of any one of claims 1 to 4, further comprising a transmitting body whose light transmittance is higher than that of the sealing body,
wherein the transmitting body blocks the other end portion of the light transmitting section in the axis direction.

6. The optical element sealing structure of claim 5,
wherein the sealing body and the transmitting body are made of a molding resin, and are formed by transfer molding.

7. The optical element sealing structure of claim 6,
wherein a first contact area at which the transmitting body is in contact with the mounting body is larger than a second contact area at which the transmitting body is in contact with the sealing body.

8. The optical element sealing structure of claim 6 or 7, wherein at least a part of an outer peripheral portion of the transmitting body is in contact with the mounting body.

9. The optical element sealing structure of any one of claims 6 to 8, wherein both the sealing body and the mounting body are covered with the transmitting body.

10. The optical element sealing structure of claim 5, wherein the transmitting body is attached to the mounting body or the sealing body using an adhesive.

11. The optical element sealing structure of claim 10,
wherein the adhesive has a light transmitting property and a refractive index higher than that of air, and is filled between the optical surface of the optical element and the transmitting body.

12. The optical element sealing structure of claim 10 or 11, wherein, in at least either the transmitting body or the mounting body, a positioning section is formed for positioning between the transmitting body and the mounting body.

13. The optical element sealing structure of claim 12,
wherein the light transmitting section is formed with a through hole that penetrates through the mounting body along the optical path,
the transmitting body is formed with a positioning section that fits into the through hole, and
the positioning section is tapered in shape with which the outer diameter is reduced toward the light-receiving surface of the optical element while the positioning section is fitted into the through hole.

14. The optical element sealing structure of any one of claims 10 to 13, wherein the attachment area at which the transmitting body is attached to the mounting body or the sealing body is smaller than the surface area on a side where the sealing body is in contact with the mounting body.

15. The optical element sealing structure of any one of claims 5 to 14, wherein, in the transmitting body, a lens portion formed in the shape of lens is formed on the optical path.

16. The optical element sealing structure of any one of claims 1 to 15, wherein the mounting body includes a lead frame and a sub mount, and
the optical element is mounted on the lead frame via the sub mount.

17. The optical element sealing structure of any one of claims 1 to 16, wherein the light transmitting section of the mounting body is formed with a light condensing section that narrows the optical path toward the optical surface of the optical element.

18. The optical element sealing structure of any one of claims 1 to 17, wherein, in the light transmitting section, an aperture is formed to extend along the optical path, an inner diameter thereof is increased as is away from the optical surface, and an inner surface thereof has a high light reflectivity.

19. The optical element sealing structure of any one of claims 1 to 18, wherein the mounting body is formed with an exposure surface that is exposed to the atmosphere around the sealing structure.

20. The optical element sealing structure of any one of claims 1 to 19, wherein the optical element is any one of a light-emitting diode, a semiconductor laser, and a photo diode.

21. An optical coupler comprising:
the sealing structure of the optical element of any one of claims 1 to 20, the optical coupler being capable of being optically coupled with a light transmitting medium.

22. An optical element sealing method for mounting on a mounting body an optical element having an optical surface receiving or emitting light, and sealing the optical element mounted on the mounting body using a molding resin, comprising:
a light transmitting section formation step of forming on the mounting body a light transmitting section though which light traveling along a predetermined optical path goes;
an optical element mounting step of mounting the optical element on the mounting body in.such a state the optical surface is directed to the light transmitting section, and the optical element blocks the light transmitting section at one end portion in an axis direction thereof; and
a sealing molding resin molding step of filling a mold with, in a state where the mounting body carrying thereon the optical element is attached to the mold, and in such a state that the mold blocks the light transmitting section at another end portion in the axis direction thereof, a sealing molding resin added with a filling material that increases the environmental resistance of the optical element.
